# EUROPEAN PATENT APPLICATION

(11) **EP 4 669 073 A1**
(43) Date of publication of application: **24.12.2025**
(21) Application number: 25181259.0
(22) Date of filing: 06.06.2025
(51) Int. Cl.: H10K 59/122, G09G 3/34, H10K 59/131, H10K 59/80

(54) **DISPLAY DEVICE**

(30) Priority: 18.06.2024 KR 20240079049
(71) Applicant: Samsung Display Co., Ltd., Yongin-si, Gyeonggi-do 17113 (KR)
(72) Inventor: HONG, Sungjin, 17113 Yongin-si (KR); LEE, Pilsuk, 17113 Yongin-si (KR)
(74) Representative: Walaski, Jan Filip

(57) **Abstract**

A display device includes a base layer including a display area (DA) having a plurality of pixels (PX1,PX2) and a non-display area (NDA), a first power line (PL-1) electrically connected to the plurality of pixels (PX1, PX2), and a second power line (PL2) electrically connected to the plurality of pixels (PX1, PX2). The display area is divided into a plurality of areas including a first area (AA1) and a second area (AA2). The second power line includes a second-first power line (PL2-1) that applies a first voltage (ELVSS1) to first pixels (PX1) disposed in the first area (AA1) and a second-second power line (PL2-2) that applies a second voltage (ELVSS2) to second pixels (PX2) disposed in the second area (AA2). During a first period (A1), the first voltage (ELVSS1) has a voltage level different from a voltage level of the second voltage (ELVSS2), and during a second period (A2) that does not include the first period (A1), the first voltage (ELVSS1) has a same voltage level as the second voltage (ELVSS2).

## Description

### 1. TECHNICAL FIELD

The present disclosure relates to a display device, and more particularly, to a display device with increased display quality in a display area.

### 2. DISCUSSION OF RELATED ART

Various electronic devices include a display device for displaying images to a user, such as smart phones, digital cameras, notebook computers, car navigation units, smart televisions, and the like. The display device generates an image and provides the generated image to the user through a display screen.

The display device includes a plurality of pixels that generate an image, a scan drive circuit that applies scan signals to the pixels, a data driver that applies data voltages to the pixels, and a light emission driver that applies light emission signals to the pixels. The pixels receive the data voltages in response to the scan signals. The pixels display an image by emitting light having a luminance corresponding to the data voltages in response to the light emission signals.

The pixels may display a video comprising at least one moving image and/or at least one still image. When the pixels display the video, the pixels may receive continuously updated images. When the pixels display the still image, the pixels may maintain the first image and may not receive subsequent images.

### SUMMARY

Embodiments of the present disclosure provide a display device for increasing display quality by outputting light of different luminance values through a plurality of areas of a display area.

According to an embodiment of the present disclosure, a display device includes a base layer including a display area having a plurality of pixels disposed therein and a non-display area disposed around the display area. A first power line is electrically connected to the plurality of pixels. A second power line is electrically connected to the plurality of pixels. The display area is divided into a plurality of areas including a first area and a second area. The second power line includes a second-first power line applying a first voltage to first pixels of the plurality of pixels that are disposed in the first area. A second-second power line applies a second voltage to second pixels of the plurality of pixels that are disposed in the second area. During a first period, the first voltage has a voltage level different from a voltage level of the second voltage. During a second period that does not include the first period, the first voltage has a same voltage level as the second voltage.

In an embodiment, each of the plurality of pixels may include a pixel driver that is disposed on the base layer and that includes a transistor and a light emitting element that is disposed on the transistor and that includes a first electrode, an intermediate layer disposed on the first electrode, and a second electrode disposed on the intermediate layer. The first power line may be electrically connected with the transistor, and the second power line may be electrically connected with the second electrode.

In an embodiment, the display device may further include a separator that divides the display area into the plurality of areas and has an obtuse taper angle in a cross-sectional view. The second electrode may include a second-first electrode and a second-second electrode electrically isolated from each other by the separator. The second-first electrode may be disposed in the first area, and the second-second electrode may be disposed in the second area.

In an embodiment, the second-first electrode may be electrically connected with the second-first power line, and the second-second electrode may be electrically connected with the second-second power line.

In an embodiment, the second area includes a first connection part electrically connecting the second-second power line and the second-second electrode to each other.

In an embodiment, the first connection part may include a first layer, a second layer disposed on the first layer, and a third layer disposed on the second layer. A side surface of the third layer may protrude outward from a side surface of the second layer in a horizontal direction, and the second-second electrode is in direct contact with the side surface of the second layer.

In an embodiment, a tip portion may be defined by the side surface of the third layer, and the second-second electrode may be partially cut off by the tip portion.

In an embodiment, the second-second power line may include the first connection part, and the second-second electrode may directly contact the second-second power line.

In an embodiment, the display device may further include a connecting line disposed on a layer different from a layer that the second-second power line is disposed, the connecting line is electrically connected with the second-second power line through a contact hole.

In an embodiment, the connecting line may include the first connection part, and the second-second electrode may directly contact the connecting line.

In an embodiment, the first area includes a second connection part electrically connecting the second-first power line and the second-first electrode to each other.

In an embodiment, the second-first power line may be disposed in the first area.

In an embodiment, the display device may further include a pixel defining layer having an opening defined therein exposing at least a portion of the first electrode, and the separator may be disposed on the pixel defining layer.

In an embodiment, the second power line may further include a second-third power line applying a third voltage to first pixels disposed in a third area among the plurality of areas, and during the first period, the voltage level of the first voltage may be different from a voltage level of the third voltage.

In an embodiment, the second area and the third area may be spaced apart from each other with the first area therebetween.

In an embodiment, each of the second voltage and the third voltage may have a lower voltage level than the first voltage.

In an embodiment, the second-second power line may include a plurality of second-second power lines, and the second-second power lines may be electrically connected to the second pixels, respectively.

In an embodiment, the second-second power lines may extend in a first direction and may be disposed in the display area.

In an embodiment, during the first period, the first voltage may have a higher voltage level than the second voltage.

In an embodiment, the first power line may apply a first power voltage to the plurality of pixels, and the first power voltage may have a higher voltage level than the first voltage and the second voltage.

In an embodiment, the display device may further include a pad part that is disposed in the non-display area and that includes a first voltage pad receiving the first power voltage and a second voltage pad receiving the first voltage and the second voltage. The first voltage pad may be electrically connected with the first power line, and the second voltage pad may be electrically connected with the second power line.

In an embodiment, the second voltage pad may include a second-first voltage pad applying the first voltage to the second-first power line and a second-second voltage pad applying the second voltage to the second-second power line.

According to an embodiment, a display device includes a base layer including a first area and a second area surrounded by the first area, a drive element layer that is disposed on the base layer and that includes a pixel driver, a light emitting element that is disposed on the drive element layer and that includes a first electrode, an intermediate layer disposed on the first electrode, and a second electrode disposed on the intermediate layer, a first power line electrically connected to the first electrode, and a second power line electrically connected to the second electrode. The second power line includes a second-first power line and a second-second power line. The second electrode includes a second-first electrode disposed in the first area and electrically connected with the second-first power line and a second-second electrode disposed in the second area and electrically connected with the second-second power line. The second area includes a first connection part electrically connecting the second-second power line and the second-second electrode to each other.

In an embodiment, the first connection part may include a first layer, a second layer disposed on the first layer, and a third layer disposed on the second layer. A side surface of the third layer may protrude outward from a side surface of the second layer in a horizontal direction, and the second-second electrode may be in direct contact with the side surface of the second layer.

In an embodiment, a tip portion may be defined by the side surface of the third layer, and the second-second electrode may be partially cut off by the tip portion.

In an embodiment, the second-first power line may apply a first voltage to the second-first electrode, and the second-second power line may apply a second voltage to the second-second electrode.

In an embodiment, during a first period, the first voltage may have a voltage level different from a voltage level of the second voltage, and during a second period that does not include the first period, the first voltage may have a same voltage level as the second voltage.

In an embodiment, during the first period, the voltage level of the first voltage may be higher than the voltage level of the second voltage.

In an embodiment, the first area includes a second connection part electrically connecting the second-first power line and the second-first electrode to each other.

In an embodiment, the second-first power line may be disposed in the first area.

In an embodiment, the base layer may further include a third area spaced apart from the second area with the first area therebetween.

In an embodiment, the second electrode may further include a second-third electrode disposed in the third area. The third area includes a third connection part electrically connecting a second-third power line of the second power line and the second-third electrode to each other.

In an embodiment, the display device may further include a separator dividing the first area and the second area from each other and having an obtuse taper angle in a cross-sectional view, and the second-first electrode and the second-second electrode may be electrically isolated from each other by the separator.

According to an embodiment, an electronic device includes a display device including a display area having a plurality of pixels disposed therein and a non-display area disposed around the display area. The display area is divided into a plurality of areas. A first power line and a second power line are electrically connected to the plurality of pixels. The second power line includes a second-first power line applying a first voltage to the plurality of pixels that are disposed in a first area of the plurality of areas. Second-second power lines independently apply second voltages to the plurality of pixels that are disposed in different areas than the first area among the plurality of areas. During a first period, at least some of the second voltages are different from the first voltage.

In an embodiment, a separator divides the display area into the plurality of areas.

In an embodiment, the separator has an obtuse taper angle in a cross-sectional view.

In an embodiment, the separator divides the plurality of areas into a grid shape.

In an embodiment, the display area extends in a plane defined in a first direction and a second direction. The separator includes a plurality of separators extending diagonally on the display area with respect to the first and second directions. The plurality of separators is spaced apart from each other in the second direction.

### BRIEF DESCRIPTION OF THE DRAWINGS

The above and other objects and features of the present disclosure will become apparent by describing in detail embodiments thereof with reference to the accompanying drawings.
FIG. 1A is a perspective view of a display device.
FIG. 1B is an exploded perspective view of the display device.
FIG. 2 is a schematic cross-sectional view of a display module.
FIG. 3 is a block diagram of the display device.
FIGS. 4A and 4B are views illustrating an equivalent circuit of one pixel among pixels illustrated in FIG. 3.
FIG. 5 is a plan view of a display panel and a drive circuit.
FIG. 6 is an enlarged view of area AA' illustrated in FIG. 5.
FIG. 7 is a cross-sectional view of the display module corresponding to line I-I' illustrated in FIG. 6.
FIG. 8A is an enlarged view of area BB' illustrated in FIG. 7.
FIG. 8B is an enlarged view of area CC' illustrated in FIG. 7.
FIG. 9 is a cross-sectional view of a display module.
FIG. 10A is a graph depicting voltages applied to first pixels disposed in a first area illustrated in FIG. 5.
FIG. 10B is a graph depicting voltages applied to second pixels disposed in a second area illustrated in FIG. 5.
FIG. 11A is a plan view of a display panel and a drive circuit.
FIG. 11B is an enlarged view of area DD' illustrated in FIG. 11A.
FIG. 11C is a cross-sectional view of a display device corresponding to line II-II' illustrated in FIG. 11B.
FIGS. 12A to 12C are plan views of display panels.

### DETAILED DESCRIPTION OF EMBODIMENTS

Hereinafter, non-limiting embodiments of the present disclosure will be described in detail with reference to the accompanying drawings. Various changes can be made to the present disclosure, and various embodiments of the present disclosure may be implemented. Thus, specific embodiments are illustrated in the drawings and described as examples herein. However, it should be understood that embodiments of the present disclosure are not to be construed as being limited thereto and covers all modifications, equivalents, and alternatives falling within the scope of the present disclosure.

In this specification, when a component (or, an area, a layer, a part, etc.) is referred to as being "on", "connected to" or "coupled to" another component, this means that the component may be directly on, connected to, or coupled to the other component or a third component may be present therebetween. When a component is referred to as being "directly on", "directly connected to" or "directly coupled to" another component, no intervening elements may be present.

Identical reference numerals refer to identical components. Additionally, in the drawings, the thicknesses, proportions, and dimensions of components may be exaggerated for effective description.

As used herein, the term "and/or" includes all of one or more combinations defined by related components.

Terms such as first, second, and the like may be used to describe various components, but the components should not be limited by the terms. The terms may be used only for distinguishing one component from other components. For example, without departing from the scope of embodiments of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship between components illustrated in the drawings. The terms are relative concepts and are described based on directions illustrated in the drawing.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Hereinafter, embodiments of the present disclosure will be described with reference to the accompanying drawings.

The present inventive concept is directed to a display device that includes first-second and second-second power lines which may respectively provide first and second voltages to pixels in different areas of the display area, such as a first area and a second area. The level of luminance in the pixels may be efficiently and precisely customized so that a luminance in specific areas, such as the second area, may increase by decreasing the second voltage provided by the second-second power line to the pixels in the specific areas. The power lines providing independent voltages to different areas of the display area resulting in different luminance values for the specific areas increases the display quality of the display device and decreases the power consumption of the display device.

The different areas of the display area of the display device may be surrounded by a separator that physically and electrically isolates the second electrodes in the different areas from each other.

The luminance in the specific areas, such as the second area, may increase during a specific time period to have a greater luminance than in the other areas, such as the first area. The luminance in the first area and the second area may be the same as each other during other time periods.

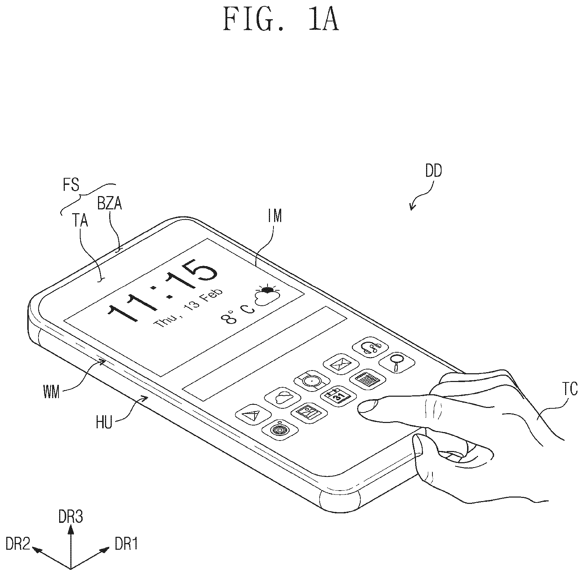

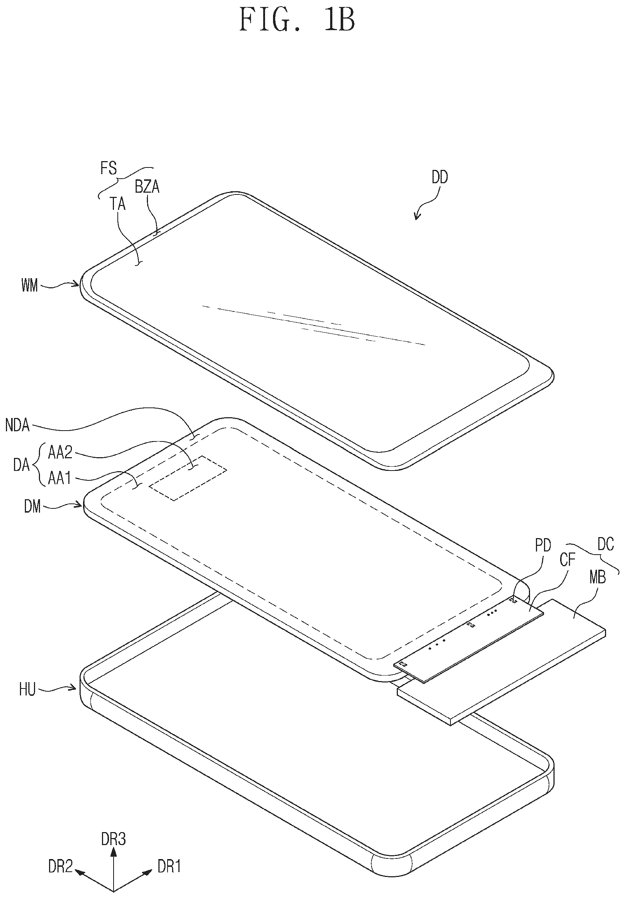

FIG. 1A is a perspective view of a display device, and FIG. 1B is an exploded perspective view of the display device.

Referring to FIGS. 1A and 1B, the display device DD may be activated depending on an electrical signal. The display device DD may include various embodiments. For example, in an embodiment the display device DD may include a tablet computer, a notebook computer, a computer, a smart television, or the like. In this embodiment, the display device DD is illustrated as a smart phone. However, embodiments are not necessarily limited thereto and the electronic device that the display device DD may be applied to may be various different small-sized, medium-sized or large-sized electronic devices.

The display device DD may display an image IM in a third direction DR3 on a display surface FS that is defined in a plane in a first direction DR1 and a second direction DR2. The first and second directions DR1, DR2 may cross each other. For example, the first and second directions DR1, DR2 may be perpendicular to each other. However, they are not necessarily limited thereto. The display surface FS on which the image IM is displayed may correspond to the front surface of the display device DD and may correspond to the front surface of a window WM. Hereinafter, the display surface and the front surface of the display device DD and the front surface of the window WM will be assigned with the same reference numeral FS. The image IM may include a still image as well as a dynamic image (e.g., a moving image). In FIG. 1A, a clock, temperature and calendar window and software application icons are illustrated as an example of the image IM. However the image is not necessarily limited thereto and the image IM may be various different subject matter.

Front surfaces (e.g., upper surfaces) and rear surfaces (e.g., lower surfaces) of members are defined based on the direction in which the image IM is displayed. The front surfaces and the rear surfaces may be opposite each other in the third direction DR3, and the normal directions of the front surfaces and the rear surfaces may be parallel to the third direction DR3. The third direction DR3 may cross the first and second directions DR1, DR2. For example, the first to third directions DR1 to DR3 may be perpendicular to each other. However, the directions indicated by the first to third directions DR1, DR2, and DR3 may be relative concepts and may be changed to other directions.

The display device DD may include the window WM, a display module DM, a drive circuit DC, and a housing HU. The window WM and the housing HU may be coupled with each other to form the exterior of the display device DD. The display device DD may further include electronic modules.

The window WM may include an optically clear insulating material. For example, the window WM may include glass or plastic. The window WM may have a multi-layer structure or a single-layer structure. For example, the window WM may include a plurality of plastic films coupled through an adhesive or may include a glass substrate and a plastic film coupled through an adhesive.

The window WM may be divided into a transmissive area TA and a bezel area BZA when viewed from above the plane. As used herein, the expression "when viewed from above the plane" may mean that it is viewed in the third direction DR3. In addition, the "thickness direction" may mean the third direction DR3.

The transmissive area TA may be an optically clear area. The bezel area BZA may have a lower light transmittance than the transmissive area TA. The bezel area BZA may define the shape of the transmissive area TA. The bezel area BZA may be adjacent to the transmissive area TA and may surround the transmissive area TA (e.g., in a plan view).

The bezel area BZA may have a certain color. The bezel area BZA may cover a non-display area NDA of the display module DM to block the non-display area NDA from being visible from the outside by the user. However, it is not necessarily limited thereto and the bezel area BZA may be omitted.

The display module DM may be disposed under the window WM. The term "under" used herein may mean the direction opposite to the direction in which the display module DM provides the image IM. The display module DM may display the image IM and may sense an input TC of a user. The display module DM includes a front surface that includes a display area DA and the non-display area NDA. The display area DA may be activated depending on an electrical signal and may be referred to as an active area.

The display area DA may be an area where the image IM is displayed and the input TC of the user is sensed at the same time. The transmissive area TA may overlap the display area DA (e.g., in the third direction DR3). For example, the transmissive area TA overlaps all or at least part of the display area DA. Accordingly, the user may visually recognize the image IM through the transmissive area TA or may provide the input TC of the user through the transmissive area TA.

The non-display area NDA may be covered by the bezel area BZA. The non-display area NDA is adjacent to the display area DA (e.g., in the first and/or second directions DR1, DR2). The non-display area NDA may surround the display area DA (e.g., in a plan view). A drive circuit or wiring for driving the display area DA may be disposed in the non-display area NDA.

The display module DM is assembled in a flat state in which the display area DA and the non-display area NDA face towards the window WM. However, this is illustrative, and a portion of the non-display area NDA may be bent. A portion of the non-display area NDA may face toward the rear surface of the display device DD, and the area of the bezel area BZA on the front surface of the display device DD may be decreased accordingly. Alternatively, the display module DM may be assembled in a state in which a portion of the display area DA is also bent. The non-display area NDA may be omitted in the display module DM.

The display area DA of the display module DM may include a plurality of areas. For example, the display area DA of the display module DM includes a first area AA1 and a second area AA2. The second area AA2 may be surrounded by the first area AA1 (e.g., in a plan view). The display area DA may further include a third area spaced apart from the second area AA2. However, the number of areas are not necessarily limited thereto and the number of the areas included in the display area DA may be four or more. Detailed description about the first area AA1 and the second area AA2 will be given below.

The drive circuit DC may be electrically connected with the display module DM. The drive circuit DC may include a main circuit board MB and a flexible film CF.

The flexible film CF is electrically connected with the display module DM. The flexible film CF may be connected to pads PD of the display module DM disposed in the non-display area NDA. The flexible film CF provides an electrical signal for driving the display module DM to the display module DM. The electrical signal may be generated from the flexible film CF or the main circuit board MB.

The main circuit board MB may include various types of drive circuits for driving the display module DM or a connector for supplying power.

The housing HU is coupled with the window WM. The housing HU coupled with the window WM provides an inner space. The display module DM may be accommodated in the inner space.

The housing HU may include a material having a relatively high rigidity. For example, the housing HU may include glass, plastic, or metal or may include a plurality of frames and/or plates formed of a combination of the aforementioned materials. The housing HU may stably protect components of the display device DD accommodated in the inner space from external impact.

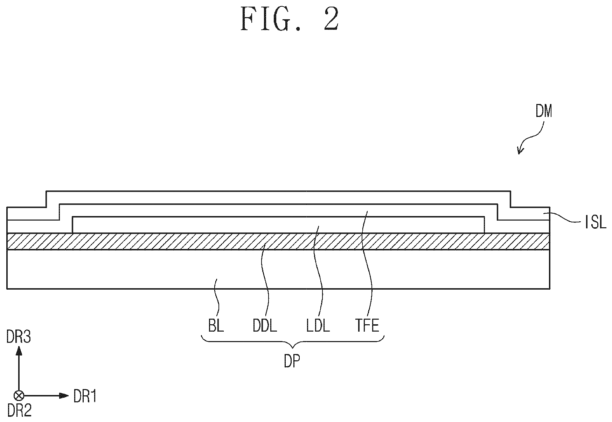

FIG. 2 is a schematic cross-sectional view of the display module.

Referring to FIG. 2, the display module DM may include a display panel DP and a sensing layer ISL. The display panel DP may include a base layer BL, a dive element layer DDL, a light emitting element layer LDL, and an encapsulation layer TFE.

The base layer BL may be a flexible substrate that is able to be bent, folded, rolled or otherwise deformed. The base layer BL may be a glass substrate, a metal substrate, or a polymer substrate. However, the base layer is not necessarily limited thereto, and the base layer BL may be an inorganic layer, an organic layer, or a composite layer. The base layer BL has substantially the same shape as the display panel DP.

The base layer BL may have a multi-layer structure. For example, the base layer BL may include a first synthetic resin layer, a second synthetic resin layer, and inorganic layers disposed therebetween. Each of the first synthetic resin layer and the second synthetic resin layer may include a polyimide-based resin. However, they are not necessarily limited thereto.

The drive element layer DDL may be disposed on the base layer BL. The drive element layer DDL may include a plurality of insulating layers, a plurality of semiconductor patterns, a plurality of conductive patterns, and signal lines. The drive element layer DDL may include a pixel drive circuit. The drive element layer DDL may be referred to as a pixel driver. Hereinafter, unless otherwise specified, when component A and component B are disposed on the same layer, it is interpreted that component A and component B are formed by the same process as each other and include the same material or have the same stacked structure as each other. Conductive patterns or semiconductor patterns disposed on the same layer may be interpreted as described above.

The light emitting element layer LDL may be disposed on the drive element layer DDL. The light emitting element layer LDL may include light emitting elements. For example, the light emitting elements may include an organic luminescent material, an inorganic luminescent material, an organic-inorganic luminescent material, a quantum dot, a quantum rod, a micro-LED, or a nano-LED.

The encapsulation layer TFE may be disposed on the light emitting element layer LDL. The encapsulation layer TFE may protect the light emitting element layer LDL, such as the light emitting elements from foreign matter such as moisture, oxygen, and dust particles. The encapsulation layer TFE may include at least one inorganic encapsulation layer. For example, the encapsulation layer TFE may include a stacked structure of a first inorganic encapsulation layer/an organic encapsulation layer/a second inorganic encapsulation layer.

The sensing layer ISL may be directly disposed on the display panel DP. The sensing layer ISL may sense a user input using, for example, an electromagnetic induction method or a capacitance method. The display panel DP and the sensing layer ISL may be formed through a continuous process. In an embodiment in which the sensing layer ISL is "directly disposed" on the display panel DP, this may mean that a third component is not disposed between the sensing layer ISL and the display panel DP. For example, a separate adhesive layer may not be disposed between the sensing ISL and the display panel DP.

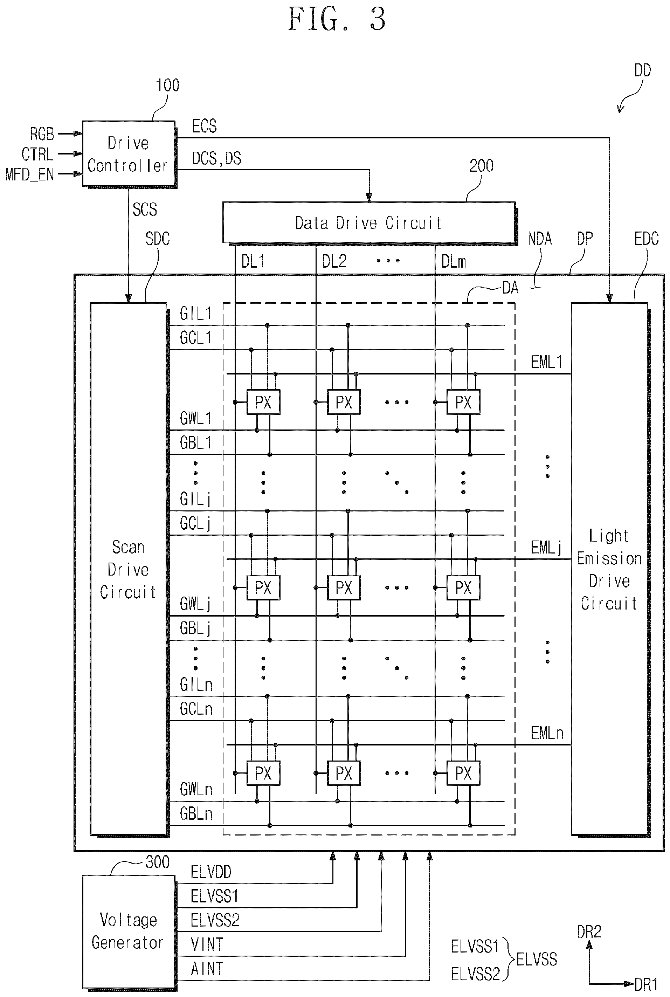

FIG. 3 is a block diagram of the display device.

Referring to FIG. 3, the display device DD may include the display panel DP, a drive controller 100, a data drive circuit 200, a scan drive circuit SDC, a light emission drive circuit EDC, and a voltage generator 300. The drive controller 100 may be defined as a timing controller.

The display panel DP may include a plurality of scan lines GIL1 to GILn, GCL1 to GCLn, GWL1 to GWLn, and GBL1 to GBLn, a plurality of light emission lines EML1 to EMLn, a plurality of data lines DL1 to DLm, and a plurality of pixels PX. "n" and "m" may be natural numbers.

The planar area of the display panel DP may include the display area DA and the non-display area NDA surrounding the display area DA. The pixels PX may be disposed in the display area DA. The pixels PX may be electrically connected to the scan lines GIL1 to GILn, GCL1 to GCLn, GWL1 to GWLn, and GBL1 to GBLn, the light emission lines EML1 to EMLn, and the data lines DL1 to DLm.

Each of the pixels PX may be electrically connected to four corresponding scan lines and one corresponding light emission line. For example, the pixels in the j-th row may be connected to the j-th scan lines GILj, GCLj, GWLj, and GBLj and the j-th light emission line EMLj. "j" may be a natural number greater than "1" and less than "n".

The scan lines GIL1 to GILn, GCL1 to GCLn, GWL1 to GWLn, and GBL1 to GBLn may include a plurality of initialization scan lines GIL1 to GILn, a plurality of compensation scan lines GCL1 to GCLn, a plurality of write scan lines GWL1 to GWLn, and a plurality of bias scan lines GBL1 to GBLn.

Each of the pixels PX may be connected to a corresponding one of the initialization scan lines GIL1 to GILn, a corresponding one of the compensation scan lines GCL1 to GCLn, a corresponding one of the write scan lines GWL1 to GWLn, and a corresponding one of the bias scan lines GBL1 to GBLn.

The scan drive circuit SDC may be disposed on a first side of the display panel DP (e.g., in the first direction DR1). The scan lines GIL1 to GILn, GCL1 to GCLn, GWL1 to GWLn, and GBL1 to GBLn may extend from the scan drive circuit SDC in the first direction DR1.

The light emission drive circuit EDC may be disposed on a second side of the display panel DP (e.g., in the first direction DR1). The light emission lines EML1 to EMLn may extend from the light emission drive circuit EDC in the direction opposite to the first direction DR1.

In FIG. 3, the scan drive circuit SDC and the light emission drive circuit EDC are disposed to face each other with the pixels PX therebetween (e.g., in the first direction DR1). However, they are not necessarily limited thereto. For example, the scan drive circuit SDC and the light emission drive circuit EDC may be disposed adjacent to each other on the first side or the second side of the display panel DP. The scan drive circuit SDC and the light emission drive circuit EDC may be implemented as one circuit.

The scan lines GIL1 to GILn, GCL1 to GCLn, GWL1 to GWLn, and GBL1 to GBLn and the light emission lines EML1 to EMLn may be arranged in the second direction DR2 so as to be spaced apart from one another. The data lines DL1 to DLm may extend from the data drive circuit 200 in the direction opposite to the second direction DR2 and may be spaced apart from one another in the first direction DR1.

The drive controller 100 may receive an image signal RGB, a control signal CTRL, and a mode signal MFD_EN. The drive controller 100 may generate an image data signal DS by converting the data format of the image signal RGB according to the specification of an interface with the data drive circuit 200. The drive controller 100 may output a scan control signal SCS, a data control signal DCS, and a light emission control signal ECS in response to the control signal CTRL.

The data drive circuit 200 may receive the data control signal DCS and the image data signal DS from the drive controller 100. The data drive circuit 200 may convert the image data signal DS into data signals and may output the data signals. The data signals may be defined as analog voltages corresponding to the gray level of the image data signal DS. The data signals may be applied to the pixels PX through the data lines DL1 to DLm.

The voltage generator 300 may generate voltages required for an operation of the display panel DP. The voltage generator 300 may generate a first power voltage ELVDD, a first voltage ELVSS1, a second voltage ELVSS2, a first initialization voltage VINT, and a second initialization voltage AINT. The first power voltage ELVDD, the second power voltage ELVSS, the first initialization voltage VINT, and the second initialization voltage AINT may be applied to the pixels PX.

The scan drive circuit SDC may receive the scan control signal SCS from the drive controller 100. The scan drive circuit SDC may output scan signals to the scan lines GIL1 to GILn, GCL1 to GCLn, GWL1 to GWLn, and GBL1 to GBLn in response to the scan control signal SCS. The scan signals may be applied to the pixels PX through the scan lines GIL1 to GILn, GCL1 to GCLn, GWL1 to GWLn, and GBL1 to GBLn.

The light emission drive circuit EDC may receive the light emission control signal ECS from the drive controller 100. The light emission drive circuit EDC may output light emission signals to the light emission lines EML1 to EMLn in response to the light emission control signal ECS. The light emission signals may be applied to the pixels PX through the light emission lines EML1 to EMLn.

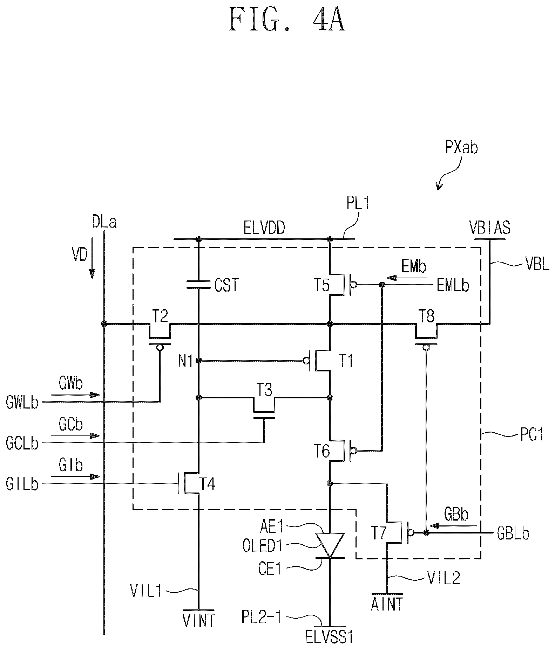

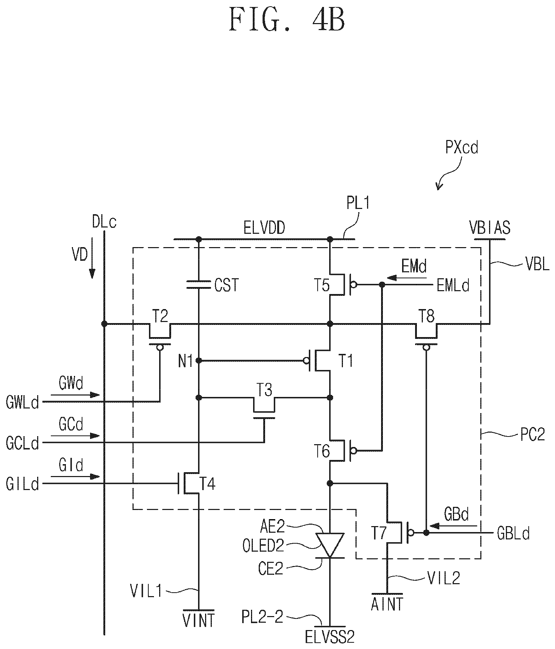

FIGS. 4A and 4B are views illustrating an equivalent circuit of one pixel among the pixels illustrated in FIG. 3.

For example, a first pixel PXab connected to the a-th data line DLa, the b-th scan lines GWLb, GCLb, GILb, and GBLb, and the b-th light emission line EMLb is illustrated in FIG. 4A. A second pixel PXcd connected to the c-th data line DLc, the d-th scan lines GWLd, GCLd, GILd, and GBLd, and the d-th light emission line EMLd is illustrated in FIG. 4B. "a" and "c" may be natural numbers less than "m", and "b" and "d" may be natural numbers less than "n". The first pixel PXab may be disposed in the first area AA1 illustrated in FIG. 1B, and the second pixel PXcd may be disposed in the second area AA2 illustrated in FIG. 1B. In the description of the first pixel PXab and the second pixel PXcd, there is a difference only in that the first voltage ELVSS1 is applied to the first pixel PXab and the second voltage ELVSS2 is applied to the second pixel PXcd, and the same description may be applied to the remaining elements.

Referring to FIG. 4A, the first pixel PXab may include a first pixel circuit PC1 and a first light emitting element OLED1 connected to the first pixel circuit PC1. The first pixel circuit PC1 may drive the first light emitting element OLED1.

The first pixel circuit PC1 may include a plurality of transistors T1 to T8 and a capacitor CST. The transistors T1 to T8 and the capacitor CST may control the amount of current flowing through the first light emitting element OLED1. The first light emitting element OLED1 may generate light having a certain luminance depending on the amount of current provided thereto.

The b-th write scan line GWLb may receive the b-th write scan signal GWb, and the b-th compensation scan line GCLb may receive the b-th compensation scan signal GCb. The b-th initialization scan line GILb may receive the b-th initialization scan signal GIb, and the b-th bias scan line GBLb may receive the b-th bias scan signal GBb. The b-th light emission line EMLb may receive the b-th light emission signal EMb.

The first pixel PXab may be connected to the a-th data line DLa, the b-th write scan line GWLb, the b-th compensation scan line GCLb, the b-th initialization scan line GILb, the b-th bias scan line GBLb, the b-th light emission line EMLb, a first initialization line VIL1, a second initialization line VIL2, a bias line VBL, a first power line PL1, and a second-first power line PL2-1.

The first initialization line VIL1 may receive the first initialization voltage VINT, and the second initialization line VIL2 may receive the second initialization voltage AINT. The bias line VBL may receive a bias voltage VBIAS. The first power line PL1 may receive the first power voltage ELVDD, and the second-first power line PL2-1 may receive the first voltage ELVSS1.

Each of the transistors T1 to T8 may include a source electrode, a drain electrode, and a gate electrode. Each of the transistors T1 to T8 may include an input electrode (e.g., a source electrode), an output electrode (e.g., a drain electrode), and a control electrode (e.g., a gate electrode). In this specification, for convenience, one of the input electrode and the output electrode may be referred to as a first electrode, and the other may be referred to as a second electrode. The transistors T1 to T8 may include the first to eighth transistors T1 to T8. The first, second, and fifth to eighth transistors T1, T2, and T5 to T8 may be PMOS transistors. The third transistor T3 and the fourth transistor T4 may be NMOS transistors. However, they are not necessarily limited thereto.

The first transistor T1 may be defined as a drive transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light emission control transistors. The eighth transistor T8 may be defined as a bias transistor.

The first light emitting element OLED1 may be defined as an organic light emitting element. The first light emitting element OLED1 may include a first anode (e.g., a first-first electrode) AE1 and a first cathode (e.g., a second-first electrode) CE1. The first anode AE1 may receive the first power voltage ELVDD through the sixth, first, and fifth transistors T6, T1, and T5. The first power voltage ELVDD may be applied to the first pixel circuit PC1 through the first power line PL1.

The first cathode CE1 may receive the first voltage ELVSS1 having a lower level than the first power voltage ELVDD. The first voltage ELVSS1 may be applied to the first pixel circuit PC1 through the second-first power line PL2-1.

The first transistor T1 may be disposed between the fifth transistor T5 and the sixth transistor T6 and may be connected to the fifth transistor T5 and the sixth transistor T6. The first transistor T1 may be connected to the first power line PL1 through the fifth transistor T5 and may be connected to the first anode AE1 through the sixth transistor T6.

The first transistor T1 may include a first electrode connected to the first power line PL1 through the fifth transistor T5, a second electrode connected to the first anode AE1 through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the first light emitting element OLED1 depending on the voltage of the first node N1 applied to the control electrode of the first transistor T1.

The second transistor T2 may be disposed between the first transistor T1 and the a-th data line DLa and may be connected to the first transistor T1 and the a-th data line DLa. The second transistor T2 may include a first electrode connected to the a-th data line DLa, a second electrode connected to the first electrode of the first transistor T1, and a control electrode connected to the b-th write scan line GWLb.

The second transistor T2 may be turned on by the b-th write scan signal GWb applied through the b-th write scan line GWLb and may electrically connect the a-th data line DLa and the first electrode of the first transistor T1. The second transistor T2 may perform a switching operation of providing a data voltage VD (corresponding to the above-described data signal) applied through the a-th data line DLa to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a control electrode connected to the b-th compensation scan line GCLb.

The third transistor T3 may be turned on by the b-th compensation scan signal GCb applied through the b-th compensation scan line GCLb and may electrically connect the second electrode of the first transistor T1 and the control electrode of the first transistor T1. When the third transistor T3 is turned on, the first transistor T1 and the third transistor T3 may be connected in the form of a diode.

The fourth transistor T4 may be connected to the first node N1. The fourth transistor T4 may include a first electrode connected to the first node N1, a second electrode connected to the first initialization line VIL1, and a control electrode connected to the b-th initialization scan line GILb. The fourth transistor T4 may be turned on by the b-th initialization scan signal GIb applied through the b-th initialization scan line GILb and may provide the first initialization voltage VINT applied through the first initialization line VIL1 to the first node N1.

The fifth transistor T5 may include a first electrode connected to the first power line PL1, a second electrode connected to the first electrode of the first transistor T1, and a control electrode connected to the b-th light emission line EMLb.

The sixth transistor T6 may include a first electrode connected to the second electrode of the first transistor T1, a second electrode connected to the first anode AE1, and a control electrode connected to the b-th light emission line EMLb.

The fifth transistor T5 and the sixth transistor T6 may be turned on by the b-th light emission signal EMb applied through the b-th light emission line EMLb. The first power voltage ELVDD may be provided to the first light emitting element OLED1 by the turned-on fifth transistor T5 and the turned-on sixth transistor T6, and a drive current may flow through the first light emitting element OLED1. Accordingly, the first light emitting element OLED1 may emit light.

The seventh transistor T7 may include a first electrode connected to the first anode AE1, a second electrode connected to the second initialization line VIL2, and a control electrode connected to the b-th bias scan line GBLb. The seventh transistor T7 may be turned on by the b-th bias scan signal GBb applied through the b-th bias scan line GBLb and may provide the second initialization voltage AINT received through the second initialization line VIL2 to the first anode AE1 of the first light emitting element OLED1.

However, embodiments of the present disclosure are not necessarily limited thereto. For example, the seventh transistor T7 may be omitted. The second initialization voltage AINT may have a voltage level different from that of the first initialization voltage VINT. However, the second initialization voltage AINT may have the same voltage level as the first initialization voltage VINT.

The seventh transistor T7 may increase the ability of the first pixel PXab to express black. When the seventh transistor T7 is turned on, a parasitic capacitor of the first light emitting element OLED1 may be discharged. Accordingly, when black luminance is implemented, the first light emitting element OLED1 does not emit light due to a leakage current of the first transistor T1, and thus the ability to express black may be increased.

The capacitor CST may include a first electrode connected to the first power line PL1 and a second electrode connected to the first node N1. When the fifth transistor T5 and the sixth transistor T6 are turned on, the amount of current flowing through the first transistor T1 may be determined depending on the voltage stored in the capacitor CST.

The eighth transistor T8 may include a first electrode connected to the bias line VBL, a second electrode connected to the first electrode of the first transistor T1, and a control electrode connected to the b-th bias scan line GBLb.

The eighth transistor T8 may be turned on by the b-th bias scan signal GBb and may provide the bias voltage VBIAS to the first electrode of the first transistor T1.

Referring to FIG. 4B, the second pixel PXcd may include a second pixel circuit PC2 and a second light emitting element OLED2 connected to the second pixel circuit PC2. The second pixel circuit PC2 may drive the second light emitting element OLED2. The second pixel circuit PC2 may include a plurality of transistors T1 to T8 and a capacitor CST. The transistors T1 to T8 and the capacitor CST may control the amount of current flowing through the second light emitting element OLED2. The second light emitting element OLED2 may generate light having a certain luminance depending on the amount of current provided thereto.

In particular, unlike the first cathode CE1 of the first light emitting element OLED1, a second cathode (e.g., a second-second electrode) CE2 of the second light emitting element OLED2 may be connected to (e.g., electrically connected thereto) a second-second power line PL2-2 and may receive the second voltage EVLSS2. The second voltage ELVSS2 may have a lower voltage level than the first voltage ELVSS1.

Accordingly, the second light emitting element OLED2 may emit light depending on a voltage corresponding to a difference between a signal transferred through the sixth transistor T6 and the second voltage EVLSS2. For example, even though a signal having the same magnitude as a signal input to the first anode AE1 of the first light emitting element OLED1 is transferred to the second anode AE2 of the second light emitting element OLED2, the drive current of the second light emitting element OLED2 is increased by the difference between the second voltage ELVSS2 and the first voltage ELVSS1. Accordingly, under the same input signal, the second light emitting element OLED2 may output light having a higher luminance than that output from the first light emitting element OLED1.

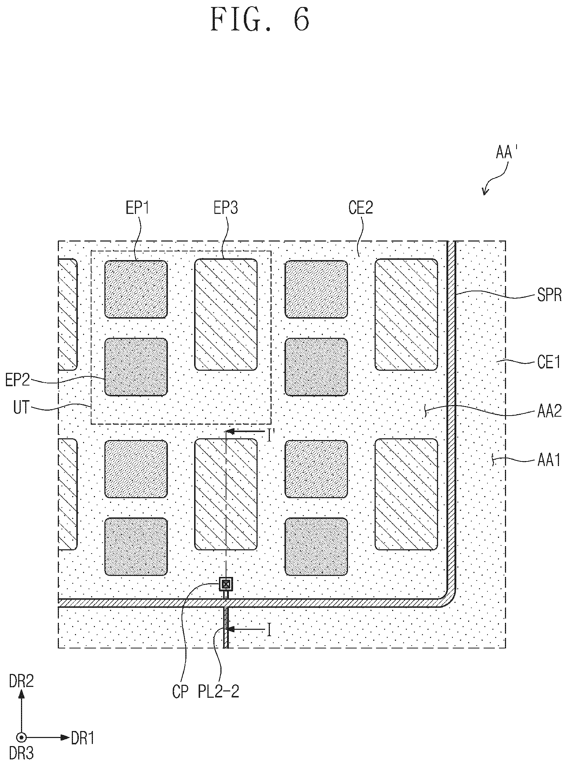

In addition, as will be described below, the second-first electrode CE1 (refer to FIG. 6) and the second-second electrode CE2 (refer to FIG. 6) may be separated from each other, and the first voltage ELVSS1 received by the first light emitting element OLED1 through the second-first power line PL2-1 may be different from the second voltage ELVSS2 received by the second light emitting element OLED2 through the second-second power line PL2-2.

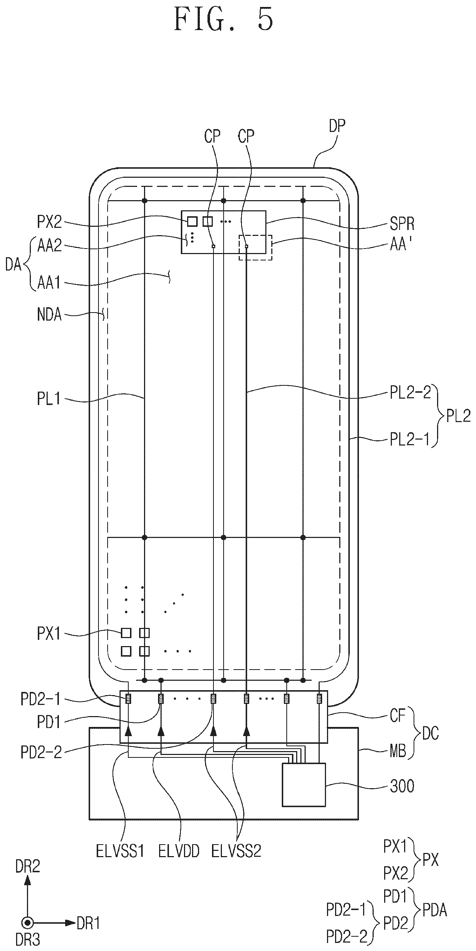

FIG. 5 is a plan view of the display panel and the drive circuit.

Referring to FIG. 5, the display panel DP may be divided into a plurality of areas (e.g., a plurality of display areas). For example, the first area AA1 and the second area AA2 may be defined in the display area DA of the display panel DP. The first area AA1 and the second area AA2 may be divided from each other by a separator SPR.

The first area AA1 and the second area AA2 may be adjacent to each other (e.g., in the first and/or second directions DR1, DR2). The second area AA2 may have a quadrangular shape, and at least one side that defines the second area AA2 may be adjacent to the first area AA1. The second area AA2 may be surrounded by the first area AA1 (e.g., in a plan view). Although FIG. 5 illustrates an example that the display area DA includes only the first area AA1 and the second area AA2, it is not necessarily limited thereto. For example, the display area DA may further include a third area divided from the first area AA1 and the second area AA2 by the separator SPR or four or more areas divided from each other by the separator SPR. The second area AA2 may be defined on the upper side of the display panel DP when viewed from above the plane.

The pixels PX may be arranged in the first direction DR1 and the second direction DR2. The pixels PX may include a plurality of pixel rows that extend in the first direction DR1 and that are arranged in the second direction DR2 and a plurality of pixel columns that extend in the second direction DR2 and that are arranged in the first direction DR1.

The pixels PX may include first pixels PX1 and second pixels PX2. The first pixels PX1 may be disposed in the first area AA1, and the second pixels PX2 may be disposed in the second area AA2. Each of the first pixels PX1 and the second pixels PX2 may be a pixel that generates light. The number of first pixels PX1 and the number of second pixels PX2 in the same area may be different from each other. For example, the number of second pixels PX2 may be less than the number of first pixels PX1. The first pixels PX1 and the second pixels PX2 may have substantially the same configuration.

A pad part PDA may include first pads PD1 and second pads PD2. The pad part PDA may be a part to which the flexible film CF is connected. The pad part PDA may include various pads such as a data pad or an input pad. However, in the present disclosure, only the pads PD1 and PD2 related to the voltages provided to the pixels PX are illustrated for convenience of explanation.

The pad part PDA may overlap the non-display area NDA (e.g., in the third direction DR3). The pad part PDA may be disposed adjacent to the lower end of the display panel DP. However, the arrangement of the pad part PDA is not necessarily limited thereto, and the pad part PDA may be disposed in various positions.

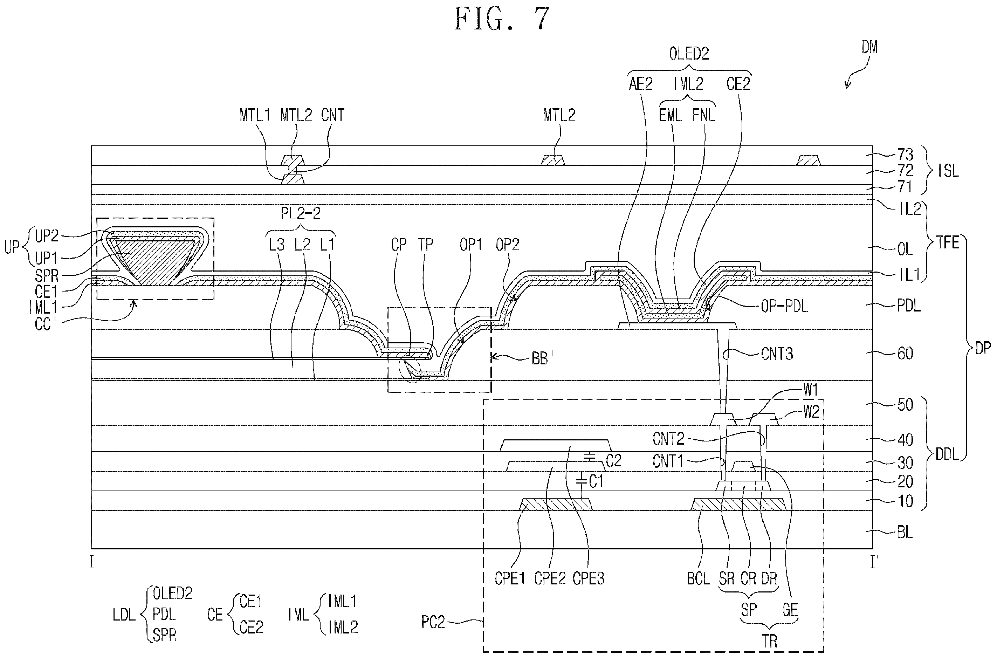

The first pads PD1 may be disposed in the non-display area NDA and may receive the first power voltage ELVDD. The first pads PD1 may be electrically connected to the pixels PX1 and may provide the first power voltage ELVDD to the first-first electrode AE1 (refer to FIG. 7) of the pixels PX. The second pads PD2 may be disposed in the non-display area NDA and may receive the first voltage ELVSS1 and the second voltage ELVSS2 that are different from the first power voltage ELVDD. The second pads PD2 may include second-first pads PD2-1 that receive the first voltage ELVSS1 and second-second pads PD2-2 that receive the second voltage ELVSS2. The second-first pads PD2-1 may be electrically connected to the first pixels PX1 and may provide the first voltage ELVSS1 to the second-first electrode CE1 (refer to FIG. 6) of the first pixels PX1, and the second-second pads PD2-2 may be electrically connected to the second pixels PX2 and may provide the second voltage ELVSS2 to the second-second electrode CE2 (refer to FIG. 6) of the second pixels PX2.

The display panel DP may include the first power line PL1 and the second power line PL2. The first power line PL1 may overlap the display area DA and may extend in the first direction DR1 or the second direction DR2. The first power line PL1 may cross the display area DA in the first direction DR1 or the second direction DR2. A plurality of first power lines PL1 may be provided. The first power lines PL1 may extend in the second direction DR2 and may be arranged in the first direction DR1. The first power lines PL1 may extend in the first direction DR1 and may be arranged in the second direction DR2. One first power line PL1 may be disposed for each of the pixel columns extending in the second direction DR2, and one first power line PL1 may be disposed for each of the pixel rows extending in the first direction DR1.

The first power lines PL1 may be electrically connected to the first pads PD1. Each of the first power lines PL1 may be electrically connected to the pixels PX. One first power line PL1 among the first power lines PL1 may be electrically connected with the pixels PX constituting the pixel column extending in the second direction DR2. Each of the first power lines PL1 may be electrically connected to the first pixels PX1 and the second pixels PX2. The first power line PL1 may be electrically connected to the first-first electrode AE1 (refer to FIG. 7) of the first pixels PX1 and the second pixels PX2 and may provide the first power voltage ELVDD to the first-first electrode AE1 (refer to FIG. 7) of the first pixels PX1 and the second pixels PX2.

The second power line PL2 may include the second-first power line PL2-1 and the second-second power line PL2-2. The second-first power line PL2-1 may overlap the non-display area NDA. The second-first power line PL2-1 may be disposed to surround three sides of the display area DA. For example, the second-first power line PL2-1 may be disposed to surround three sides of the first area AA1. The second-first power line PL2-1 may be electrically connected to the first pixels PX1. The second-first power line PL2-1 may be electrically connected to the second-first electrode CE1 (refer to FIG. 6) of the first pixels PX1 and may provide the first voltage ELVSS1 to the second-first electrode CE1 (refer to FIG. 6) of the first pixels PX1.

The second-second power line PL2-2 may overlap the display area DA. The second-second power line PL2-2 may extend in the second direction DR2. The second-second power line PL2-2 may overlap the first area AA1 and the second area AA2. For example, the second-second power line PL2-2 may cross the first area AA1 and may extend to a specific position in the second area AA2. A plurality of second-second power lines PL2-2 may be provided. The second-second power lines PL2-2 may extend in the second direction DR2 and may be arranged in the first direction DR1. Although two second-second power lines PL2-2 are illustrated in FIG. 5, the number is not necessarily limited thereto, and three or more second-second power lines PL2-2 may be provided. The second-second power line PL2-2 may be electrically connected to the second pixels PX2. The second-second power line PL2-2 may be electrically connected to the second-second electrode CE2 (refer to FIG. 6) of the second pixels PX2 and may provide the second voltage ELVSS2 to the second-second electrode CE2 (refer to FIG. 6) of the second pixels PX2. For example, the second-second power line PL2-2 may supply the second voltage ELVSS2 to the second-second electrode CE2 (refer to FIG. 6) through a connection part CP. A plurality of connection parts CP may be provided. In FIG. 5, the same number of connection parts CP as the second-second power lines PL2-2, such as two connection parts CP are illustrated. However, they are not necessarily limited thereto, and the number of connection parts CP may be three or more, such as depending on the number of second-second power lines PL2-2.

The voltage generator 300 may be disposed on the main circuit board MB. The voltage generator 300 may generate the first power voltage ELVDD, the first voltage ELVSS1, and the second voltage ELVSS2. The pad part PDA may be electrically connected with the voltage generator 300. The voltage generator 300 may be electrically connected with the first power line PL1 and the second power line PL2 through the pad part PDA. The voltage generator 300 may apply the first power voltage ELVDD to the first pads PD1, may apply the first voltage ELVSS1 to the second-first pads PD2-1, and may apply the second voltage ELVSS2 to the second-second pads PD2-2. Thus, the voltage generator 300 may supply the first power voltage ELVDD to the first-first electrode AE1 of the first pixels PX1 and the second pixels PX2, may supply the first voltage ELVSS1 to the second-first electrode CE1 of the first pixels PX1, and may supply the second voltage ELVSS2 to the second-second electrode CE2 of the second pixels PX2.

FIG. 6 is an enlarged view of area AA' illustrated in FIG. 5.

Among the components of the display panel DP, a plurality of light emitting units UT, the separator SPR, the second electrodes CE1 and CE2 separated from each other by the separator SPR, and the second-second power line PL2-2 are illustrated in FIG. 6. The first-second electrode AE2 (refer to FIG. 7) will be described below.

One light emitting unit UT among the plurality of light emitting units UT may include three light emitting parts EP1, EP2, and EP3. The light emitting units UT may be arranged in the first direction DR1 and the second direction DR2. However, they are not necessarily limited thereto and the number and arrangement of light emitting units UT may be designed in various ways.

Each of the light emitting parts EP1, EP2, and EP3 may correspond to a light emitting opening OP-PDL (refer to FIG. 7) that will be described below. For example, each of the light emitting parts EP1, EP2, and EP3 may be an area where light is emitted by the above-described light emitting element (e.g., the second light emitting element OLED2 illustrated in FIG. 4) and may correspond to a unit that forms an image displayed on the display panel DP. For example, each of the light emitting parts EP1, EP2, and EP3 may correspond to an area defined by the light emitting opening OP-PDL (refer to FIG. 7) that will be described below, particularly, an area defined by the lower surface of the light emitting opening OP-PDL.

The light emitting parts EP1, EP2, and EP3 may include the first light emitting part EP1, the second light emitting part EP2, and the third light emitting part EP3. The first light emitting part EP1, the second light emitting part EP2, and the third light emitting part EP3 may emit light of different colors from each other. Accordingly, a light emitting element constituting the first light emitting part EP1, a light emitting element constituting the second light emitting part EP2, and a light emitting element constituting the third light emitting part EP3 may emit light of different colors from each other. For example, the first light emitting part EP1 may emit red light, the second light emitting part EP2 may emit green light, and the third light emitting part EP3 may emit blue light. However, a combination of colors respectively emitted by the light emitting parts is not necessarily limited thereto. Alternatively, at least two of the light emitting parts EP1, EP2, and EP3 may emit light of the same color as each other. For example, the first to third light emitting parts EP1, EP2, and EP3 may all emit blue light or white light.

Unlike that illustrated in FIG. 6, the third light emitting part EP3 among the light emitting parts EP1, EP2, and EP3 may include two sub-light emitting parts spaced apart from each other in the second direction DR2. Alternatively, at least one of the light emitting parts EP1 and EP2 may include sub-light emitting parts spaced apart from each other and is not necessarily limited.

The second electrodes CE1 and CE2 may include the second-first electrode CE1 disposed in the first area AA1 and the second-second electrode CE2 disposed in the second area AA2. The first area AA1 and the second area AA2 may be divided from each other by the separator SPR. The second-first electrode CE1 and the second-second electrode CE2 may be electrically isolated from each other by the separator SPR. Each of the second-first electrode CE1 and the second-second electrode CE2 may be a common electrode and may be commonly deposited by an open mask.

The second-second power line PL2-2 may be disposed to overlap the first area AA1 and the second area AA2. A plurality of second-second power lines PL2-2 may be provided, and only one second-second power line PL2-2 among the plurality of second-second power lines PL2-2 is illustrated in FIG. 6. The second-second power line PL2-2 may be electrically connected with the second-second electrode CE2, such as through the connection part CP. The second-second power line PL2-2 may apply the second voltage ELVSS2 (refer to FIG. 5) to the second-second electrode CE2.

The second-second power line PL2-2 may include the connection part (e.g., the first connection part) CP. The connection part CP may be provided on one side of the second-second power line PL2-2. Detailed description about the connection part CP will be given below.

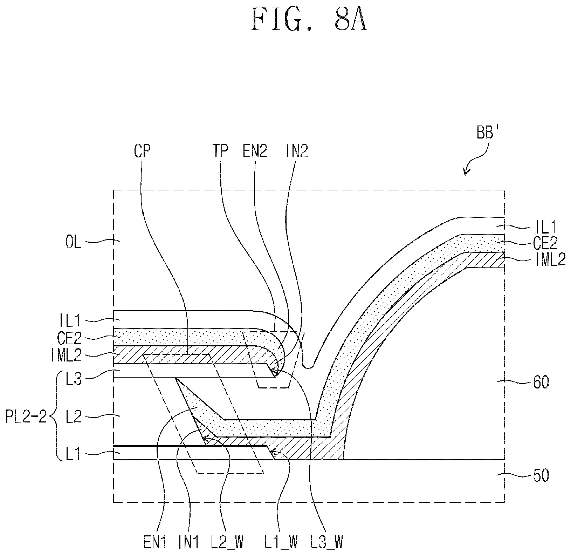

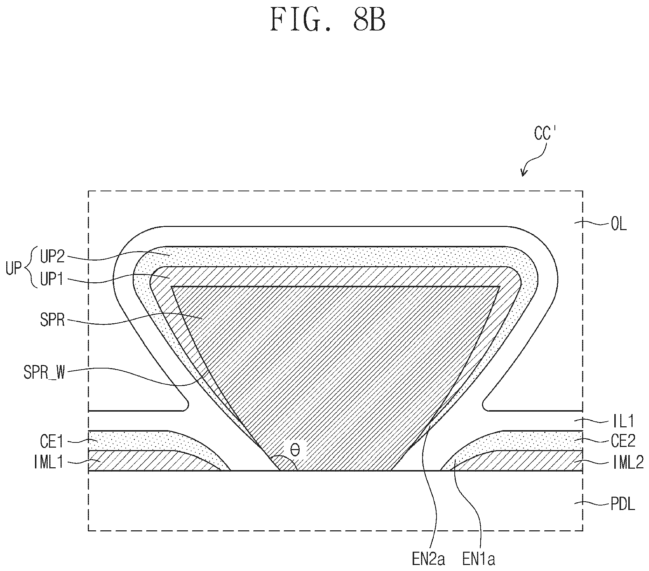

FIG. 7 is a cross-sectional view of the display module corresponding to line I-I' illustrated in FIG. 6. FIG. 8A is an enlarged view of area BB' illustrated in FIG. 7. FIG. 8B is an enlarged view of area CC' illustrated in FIG. 7.

Referring to FIG. 7, the display panel DP may include the base layer BL, the drive element layer DDL, the light emitting element layer LDL, the encapsulation layer TFE, and the sensing layer ISL. The drive element layer DDL may include a plurality of insulating layers 10, 20, 30, 40, and 50 disposed on the base layer BL, and a plurality of conductive patterns and a plurality of semiconductor patterns disposed between the insulating layers. The conductive patterns and the semiconductor patterns disposed between the insulating layers may constitute the second pixel circuit PC2. For ease of description, FIG. 7 illustrates a section of one area where one of the plurality of light emitting parts disposed in the second area AA2 illustrated in FIG. 6 is disposed.

The base layer BL may be a member that provides a base surface on which the second pixel circuit PC2 is disposed. The base layer BL may be a rigid substrate or may be a flexible substrate that is able to be bent, folded, rolled or otherwise deformed. The base layer BL may be a glass substrate, a metal substrate, or a polymer substrate. However, it is not necessarily limited thereto, and the base layer BL may be an inorganic layer, an organic layer, or a composite layer.

The base layer BL may have a multi-layer structure. The base layer BL may include a first polymer resin layer, a silicon oxide (SiOx) layer disposed on the first polymer resin layer, an amorphous silicon (a-Si) layer disposed on the silicon oxide layer, and a second polymer resin layer disposed on the amorphous silicon layer. The silicon oxide layer and the amorphous silicon layer may be referred to as a base barrier layer.

The polymer resin layer may include a polyimide-based resin. Alternatively, the polymer resin layer may include at least one of an acrylic resin, a methacrylic resin, a polyisoprene resin, a vinyl resin, an epoxy resin, a urethane-based resin, a celluosic resin, a siloxane-based resin, a polyamide resin, and a perylene-based resin. A "~~"-based resin used herein refers to a resin containing a "~~" functional group.

Each of insulating layers, conductive layers, and semiconductor layers disposed on the base layer BL may be formed by a process such as coating or deposition. Thereafter, the insulating layers, the semiconductor layers, and the conductive layers may be selectively subjected to patterning by performing a photolithography process a plurality of times. Accordingly, holes may be formed in the insulating layers, or a semiconductor pattern, a conductive pattern, and a signal line may be formed on the insulating layers.

The drive element layer DDL may include the first to fifth insulating layers 10, 20, 30, 40, and 50 sequentially stacked on the base layer BL and the second pixel circuit PC2 (e.g., in the third direction DR3). In FIG. 7, one transistor TR and two capacitors C1 and C2 of the second pixel circuit PC2 are illustrated. Other transistors constituting the second pixel circuit PC2 may have the same structure as the transistor TR illustrated in FIG. 7. However, this is illustrative, and the other transistors constituting the second pixel circuit PC2 may have a structure different from that of the transistor TR and are not necessarily limited.

The first insulating layer 10 may be disposed on the base layer BL. The first insulating layer 10 may be an inorganic layer and/or an organic layer and may have a single-layer structure or a multi-layer structure. The first insulating layer 10 may include at least one of aluminum oxide, titanium oxide, silicon oxide, silicon nitride, silicon oxy nitride, zirconium oxide, and hafnium oxide. The first insulating layer 10 is illustrated as a single silicon oxide layer. Insulating layers to be described below may be inorganic layers and/or organic layers and may have a single-layer structure or a multi-layer structure. The inorganic layers may include at least one of the aforementioned materials, but are not necessarily limited thereto.

The first insulating layer 10 may cover a lower conductive layer BCL. For example, the display panel DP may further include the lower conductive layer BCL disposed to overlap the transistor TR. The lower conductive layer BCL may block an influence of an electrical potential due to a polarization phenomenon of the base layer BL on the transistor TR. In addition, the lower conductive layer BCL may block light incident towards the transistor TR from below. At least one of an inorganic barrier layer and a buffer layer may be additionally disposed between the lower conductive layer BCL and the base layer BL.

The lower conductive layer BCL may include reflective metal. For example, the lower conductive layer BCL may include titanium (TI), molybdenum (Mo), an alloy containing molybdenum, aluminum (Al), an alloy containing aluminum, aluminum nitride (AIN), tungsten (W), tungsten nitride (WN), and copper (Cu).

The lower conductive layer BCL may be connected with (e.g. electrically connected therewith) a source of the transistor TR through a source electrode pattern W1. The lower conductive layer BCL may be synchronized with the source of the transistor TR. However, this is illustrative, and the lower conductive layer BCL may be connected to a gate of the transistor TR and may be synchronized with the gate. Alternatively, the lower conductive layer BCL may be connected to another electrode and may independently receive a constant voltage or a pulse signal. The lower conductive layer BCL may be provided in a form isolated from another conductive pattern. The lower conductive layer BCL may be provided in various forms and is not necessarily limited.

The transistor TR may be disposed on the first insulating layer 10. The transistor TR may include a semiconductor pattern SP and a gate electrode GE. The semiconductor pattern SP may be disposed on the first insulating layer 10. The semiconductor pattern SP may include an oxide semiconductor. For example, the oxide semiconductor may include transparent conductive oxide (TCO) such as indium tin oxide (ITO), indium zinc oxide (IZO), indium gallium zinc oxide (IGZO), zinc oxide (ZnOx), or indium oxide (In₂O₃). However, without being necessarily limited thereto, the semiconductor pattern may include amorphous silicon, low-temperature polycrystalline silicon, or polycrystalline silicon.

The semiconductor pattern SP may include a source area SR, a drain area DR, and a channel area CR that are distinguished from one another depending on the degree of conductivity. The channel area CR may be a portion overlapping the gate electrode GE when viewed from above the plane. The source area SR and the drain area DR may be portions spaced apart from each other with the channel area CR therebetween. In an embodiment in which the semiconductor pattern SP is an oxide semiconductor, the source area SR and the drain area DR may be reduced areas. Accordingly, the source area SR and the drain area DR may have higher reduced-metal content than the channel area CR. Alternatively, in an embodiment in which the semiconductor pattern SP is polycrystalline silicon, the source area SR and the drain area DR may be highly doped areas.

The source area SR and the drain area DR may have a higher conductivity than the channel area CR. The source area SR may correspond to the source electrode of the transistor TR, and the drain area DR may correspond to the drain electrode of the transistor TR. As illustrated in FIG. 7, the source electrode pattern W1 and a drain electrode pattern W2 connected to the source area SR and the drain area DR, respectively, may be further included. For example, each of the source electrode pattern W1 and the drain electrode pattern W2 may be integrally formed with one of lines constituting the second pixel circuit PC2 and is not necessarily limited.

The second insulating layer 20 may commonly overlap a plurality of pixels and may cover the semiconductor pattern SP. The second insulating layer 20 may be an inorganic layer and/or an organic layer and may have a single-layer structure or a multi-layer structure. The second insulating layer 20 may include at least one of aluminum oxide, titanium oxide, silicon oxide, silicon nitride, silicon oxy nitride, zirconium oxide, and hafnium oxide. For example, the second insulating layer 20 may be a single silicon oxide layer.

The gate electrode GE may be disposed on the second insulating layer 20. The gate electrode GE may correspond to the gate of the transistor TR. In addition, the gate electrode GE may be disposed over the semiconductor pattern SP. However, this is illustrative, and the gate electrode GE may be disposed under the semiconductor pattern SP and is not necessarily limited.

The gate electrode GE may include titanium (TI), silver (Ag), molybdenum (Mo), aluminum (Al), aluminum nitride (AIN), tungsten (W), tungsten nitride (WN), copper (Cu), or an alloy thereof, but is not necessarily limited thereto.

The third insulating layer 30 may be disposed on the gate electrode GE. The third insulating layer 30 may be an inorganic layer and/or an organic layer and may have a single-layer structure or a multi-layer structure. The third insulating layer 30 may include at least one of aluminum oxide, titanium oxide, silicon oxide, silicon nitride, silicon oxy nitride, zirconium oxide, and hafnium oxide.

Among a plurality of conductive patterns W1, W2, CPE1, CPE2, and CPE3, the first capacitor electrode CPE1 and the second capacitor electrode CPE2 constitute the first capacitor C1. The first capacitor electrode CPE1 and the second capacitor electrode CPE2 may be spaced apart from each other with the first insulating layer 10 and the second insulating layer 20 therebetween (e.g., in the third direction DR3).

The first capacitor electrode CPE1 and the lower conductive layer BCL may have a one-body shape. In addition, the second capacitor electrode CPE2 and the gate electrode GE may have a one-body shape. For example, the first capacitor electrode CPE1 and the lower conductive layer BCL may be integral with each other and the second capacitor electrode CPE2 and the gate electrode GE may be integral with each other.

The third capacitor electrode CPE3 may be disposed on the third insulating layer 30. The third capacitor electrode CPE3 may be spaced apart from the second capacitor electrode CPE2 with the third insulating layer 30 therebetween (e.g., in the third direction DR3) and may overlap the second capacitor electrode CPE2 when viewed from above the plane. The third capacitor electrode CPE3, together with the second capacitor electrode CPE2, may constitute the second capacitor C2.

The fourth insulating layer 40 may be disposed on the third insulating layer 30 and/or the third capacitor electrode CPE3. The fourth insulating layer 40 may be an inorganic layer and/or an organic layer and may have a single-layer structure or a multi-layer structure. The fourth insulating layer 40 may include at least one of aluminum oxide, titanium oxide, silicon oxide, silicon nitride, silicon oxy nitride, zirconium oxide, and hafnium oxide.

The source electrode pattern W1 and the drain electrode pattern W2 may be disposed on the fourth insulating layer 40. The source electrode pattern W1 may be connected to the source area SR of the transistor TR through a first contact hole CNT1, and the source electrode pattern W1 and the source area SR of the semiconductor pattern SP may function as the source of the transistor TR. The drain electrode pattern W2 may be connected to the drain area DR of the transistor TR through a second contact hole CNT2, and the drain electrode pattern W2 and the drain area DR of the semiconductor pattern SP may function as the drain of the transistor TR. The fifth insulating layer 50 may be disposed on the source electrode pattern W1 and the drain electrode pattern W2.

The second-second power line PL2-2 may be disposed on the fifth insulating layer 50 (e.g., disposed directly thereon in the third direction DR3). The second-second power line PL2-2 may be electrically connected with the second light emitting element OLED2, such as b the connection part CP. The second-second power line PL2-2 may have a three-layer structure. For example, the second-second power line PL2-2 may include a first layer L1, a second layer L2, and a third layer L3 sequentially stacked one above another in the third direction DR3. Detailed description thereabout will be given below.

A sixth insulating layer 60 may be disposed on (e.g., disposed directly thereon) the second-second power line PL2-2. The sixth insulating layer 60 may be disposed on the fifth insulating layer 50 and may cover the second-second power line PL2-2. Each of the fifth insulating layer 50 and the sixth insulating layer 60 may be an organic layer. For example, each of the fifth insulating layer 50 and the sixth insulating layer 60 may include a general purpose polymer, such as benzocyclobutene (BCB), polyimide, hexamethyldisiloxane (HMDSO), Polymethylmethacrylate (PMMA), or Polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, or a blend thereof.

The sixth insulating layer 60 may include a first opening OP1 that exposes at least a portion of the second-second power line PL2-2. The second-second power line PL2-2 may be electrically connected with the second light emitting element OLED2 through the portion exposed from the sixth insulating layer 60. Detailed description thereabout will be given below. However, implementations are not necessarily limited thereto. For example, the sixth insulating layer 60 may be omitted, or a plurality of sixth insulating layers 60 may be provided.

The light emitting element layer LDL may be disposed on the sixth insulating layer 60. The light emitting element layer LDL may include a pixel defining layer PDL, the second light emitting element OLED2, and the separator SPR. The pixel defining layer PDL may be an organic layer. For example, the pixel defining layer PDL may include a general purpose polymer, such as benzocyclobutene (BCB), polyimide, hexamethyldisiloxane (HMDSO), Polymethylmethacrylate (PMMA), or Polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, or a blend thereof.

The pixel defining layer PDL may have a property of absorbing light. For example, the pixel defining layer PDL may be black in color. For example, the pixel defining layer PDL may include a black coloring agent. The black coloring agent may include a black dye or a black pigment. The black coloring agent may include carbon black, metal such as chromium, or oxide thereof. The pixel defining layer PDL may correspond to a light blocking pattern having light-blocking characteristics.

The opening OP-PDL (hereinafter, referred to as the light emitting opening) for exposing at least a portion of the first-second electrode AE2 that will be described below may be defined in the pixel defining layer PDL. A plurality of light emitting openings OP-PDL may be provided. The plurality of light emitting openings OP-PDL may be disposed to correspond to light emitting elements, respectively. All components of the second light emitting element OLED2 may be disposed in the light emitting opening OP-PDL to overlap one another (e.g., in the third direction DR3), and the light emitting opening OP-PDL may be an area where light emitted by the second light emitting element OLED2 is substantially displayed. Accordingly, the shape of the third light emitting part EP3 among the above-described light emitting parts EP1, EP2, and EP3 (refer to FIG. 6) may substantially correspond to the planar shape of the light emitting opening OP-PDL.

The second light emitting element OLED2 may include the first-second electrode AE2, a second intermediate layer IML2, and the second-second electrode CE2. The first-second electrode AE2 may be a transflective electrode, a transmissive electrode, or a reflective electrode. The first-second electrode AE2 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), or a compound thereof and a transparent or translucent electrode layer formed on the reflective layer. The transparent or translucent electrode layer may include at least one selected from the group consisting of indium tin oxide (ITO), indium zinc oxide (IZO), indium gallium zinc oxide (IGZO), zinc oxide (ZnO), or indium oxide (In₂O₃) and aluminum-doped zinc oxide (AZO). For example, the first-second electrode AE2 may include a stacked structure of ITO/Ag/ITO.

The first-second electrode AE2 may be the anode of the second light emitting element OLED2. For example, the first-second electrode AE2 may be connected to the transistor TR through a third contact hole CNT3 formed through the fifth insulating layer 50 and the sixth insulating layer 60. For example, the first-second electrode AE2 may be connected with the source of the transistor TR through the source electrode pattern W1 connected to the third contact hole CNT3.

The second intermediate layer IML2 may be disposed between the first-second electrode AE2 and the second-second electrode CE2 (e.g., in the third direction DR3). The second intermediate layer IML2 may include an emissive layer EML and a functional layer FNL. However, the second light emitting element OLED2 may include the second intermediate layer IML2 having various structures and is not necessarily limited. For example, the functional layer FNL may include a plurality of layers or may include two or more layers spaced apart from each other with the emissive layer EML therebetween (e.g., in the third direction DR3). Alternatively, the functional layer FNL may be omitted.

The emissive layer EML may include an organic luminescent material. Alternatively, the emissive layer EML may include an inorganic luminescent material or may include a mixed layer of an organic luminescent material and an inorganic luminescent material. The emissive layer EML may provide one of red light, green light, and blue light. However, without being necessarily limited thereto, the emissive layers EML disposed in all of the light emitting parts EP1, EP2, and EP3 (refer to FIG. 6) may include a luminescent material that displays the same color. The emissive layers EML may provide blue light or white light. FIG. 7 illustrates an example in which the emissive layer EML and the functional layer FNL have different shapes from each other. However, they are not necessarily limited thereto, and the emissive layer EML and the functional layer FNL may be disposed in the same shape when viewed from above the plane.

The functional layer FNL may be disposed between the first-second electrode AE2 and the second-second electrode CE2 (e.g., in the third direction DR3). For example, the functional layer FNL may be disposed between the first-second electrode AE2 and the emissive layer EML or may be disposed between the second-second electrode CE2 and the emissive layer EML. Alternatively, the functional layer FNL may be disposed between both the first-second electrode AE2 and the emissive layer EML and between the second-second electrode CE2 and the emissive layer EML. The emissive layer EML is illustrated as being inserted into the functional layer FNL. However, this is illustrative, and the functional layer FNL may include a layer disposed between the emissive layer EML and the first-second electrode AE2 and/or a layer disposed between the emissive layer EML and the second-second electrode CE2 and is not necessarily limited.

The functional layer FNL may control the movement of charges between the first-second electrode AE2 and the second-second electrode CE2. The functional layer FNL may include a hole injection/transport material and/or an electron injection/transport material. The functional layer FNL may include at least one of an electron blocking layer, a hole transport layer, a hole injection layer, a hole blocking layer, an electron transport layer, an electron injection layer, and a charge generating layer.

The second-second electrode CE2 may be disposed on the second intermediate layer IML2. As described above, the second-second electrode CE2 may be connected to the connection part CP and may be electrically connected to the second-second power line PL2-2 accordingly. As described above, the second-second power line PL2-2 may include the connection part CP. The connection part CP may be a part that is defined in an area exposed from the sixth insulating layer 60 and to which the second-second electrode CE2 is connected. A tip portion TP may be defined at the connection part CP.

The connection part CP of the second-second power line PL2-2 will be described in more detail with reference to FIGS. 7 and 8A. As illustrated in FIGS. 7 and 8A, the second-second power line PL2-2 may have a three-layer structure. For example, the second-second power line PL2-2 may include the first layer L1, the second layer L2, and the third layer L3 sequentially stacked one above another in the third direction DR3. The second layer L2 may include a material different from that of the first layer L1. In addition, the second layer L2 may include a material different from that of the third layer L3. The second layer L2 may have a greater thickness than the first layer L1. In addition, the second layer L2 may have a greater thickness than the third layer L3. The second layer L2 may include a highly conductive material. For example, The second layer L2 may include aluminum (Al).

The first layer L1 may include a material having a lower etch rate than the second layer L2. For example, the first layer L1 and the second layer L2 may be formed of materials with a relatively high etch selectivity. The first layer L1 may include titanium (Ti), and the second layer L2 may include aluminum (Al). A side surface L1_W of the first layer L1 may be defined outward of a side surface L2_W of the second layer L2. For example, the connection part CP of the second-second power line PL2-2 may have a shape in which the side surface L1_W of the first layer L1 protrudes outward from the side surface L2_W of the second layer L2 (e.g., in a horizontal direction parallel to an upper surface of the base layer BL). For example, the connection part CP of the second-second power line PL2-2 may have a shape in which the side surface L2_W of the second layer L2 is recessed inwardly from the side surface L1_W of the first layer L1.

In addition, the third layer L3 may include a material having a lower etch rate than the second layer L2. For example, the third layer L3 and the second layer L2 may be formed of materials with a relatively high etch selectivity. The third layer L3 may include titanium (Ti), and the second layer L2 may include aluminum (Al). A side surface L3_W of the third layer L3 may be defined outward of the side surface L2_W of the second layer L2. For example, the connection part CP of the second-second power line PL2-2 may have a shape in which the side surface L3_W of the third layer L3 protrudes outward from the side surface L2_W of the second layer L2 (e.g., in a horizontal direction parallel to an upper surface of the base layer BL). For example, the connection part CP of the second-second power line PL2-2 may have an undercut shape or an overhang structure, and the tip portion TP of the connection part CP may be defined by the portion of the third layer L3 that protrudes relative to the second layer L2.

The sixth insulating layer 60 and the pixel defining layer PDL may expose at least a portion of the tip portion TP and at least a portion of the second side surface L2_W. For example, the first opening OP1 that exposes one side of the second-second power line PL2-2 may be defined in the sixth insulating layer 60, and a second opening OP2 that overlaps the first opening OP1 may be defined in the pixel defining layer PDL. The planar area of the second opening OP2 may be greater than the planar area of the first opening OP1. However, it is not necessarily limited thereto, and the planar area of the second opening OP2 may be less than or equal to the planar area of the first opening OP1 as long as at least a portion of the tip portion TP and at least a portion of the second side surface L2_W are capable of being exposed.

The second intermediate layer IML2 may be disposed on the pixel defining layer PDL. The second intermediate layer IML2 may also be disposed on a partial area of the sixth insulating layer 60 exposed by the second opening OP2 of the pixel defining layer PDL. In addition, the second intermediate layer IML2 may also be disposed on a partial area of the second-second power line PL2-2 exposed by the first opening OP1 of the seventh insulating layer 60. As illustrated in FIG. 8A, the second intermediate layer IML2 may include one end IN1 disposed along the upper surface of the fifth insulating layer 50 and an opposite end IN2 disposed along the upper surface of the tip portion TP. For example, when shown in a cross-sectional view, the second intermediate layer IML2 may have a shape that is partially disconnected with respect to the tip portion TP in the area where the connection part CP is defined. However, likewise to the second-second electrode CE2, the second intermediate layer IML2, when viewed from above the plane, may have a one-body shape (e.g., an integral shape) that is entirely connected within the second area AA2 (refer to FIG. 6) that is defined as a closed line by the separator SPR.

The second-second electrode CE2 may be disposed on (e.g., disposed directly thereon) the second intermediate layer IML2. The second-second electrode CE2 may also be disposed on a partial area of the sixth insulating layer 60 exposed by the second opening OP2 of the pixel defining layer PDL. In addition, the second-second electrode CE2 may also be disposed on a partial area of the second-second power line PL2-2 exposed by the first opening OP1 of the seventh insulating layer 60. As illustrated in FIG. 8A, the second-second electrode CE2 may include one end EN1 disposed along the upper surface of the fifth insulating layer 50 and an opposite end EN2 disposed along the upper surface of the tip portion TP. For example, when shown in a cross-sectional view, the second-second electrode CE2 may have a shape that is partially disconnected with respect to the tip portion TP in the area where the connection part CP is defined. For example, the tip portion TP may partially cut off the second-second electrode CE2. However, when viewed from above the plane, the second-second electrode CE2 may have a one-body shape (e.g., an integral shape) that is entirely connected within the second area AA2 (refer to FIG. 6) that is defined as a closed curve by the separator SPR.

The one end EN1 of the second-second electrode CE2 may be disposed along the side surface of the second layer L2 and may directly contact the side surface L2_W of the second layer L2. For example, through a difference in deposition angle between the second-second electrode CE2 and the second intermediate layer IML2, the second-second electrode CE2 may be formed to be in direct contact with the side surface L2_W of the second layer L2 exposed from the second intermediate layer IML2 by the tip portion TP. For example, the second-second electrode CE2 may be connected to the second-second power line PL2-2 without a separate patterning process for the second intermediate layer IML2, and thus the second light emitting element OLED2 may be electrically connected with the second-second power line PL2-2.

Although the opposite end IN2 of the second intermediate layer IML2 and the opposite end EN2 of the second-second electrode CE2 are illustrated as covering the side surface L3_W of the third layer L3, they are not necessarily limited thereto and at least a portion of the side surface L3_W of the third layer L3 may be exposed from the opposite end IN2 of the second intermediate layer IML2 and/or the opposite end EN2 of the second-second electrode CE2.

As described above, the display panel DP may include the separator SPR. The separator SPR may be disposed on the pixel defining layer PDL (e.g., disposed directly thereon in the third direction DR3). A second electrode CE and an intermediate layer IML may be commonly formed for the plurality of pixels by deposition through an open mask. The second electrode CE may be divided into the second-first electrode CE1 and the second-second electrode CE2 by the separator SPR, and the intermediate layer IML may be divided into the first intermediate layer IML1 and the second intermediate layer IML2 by the separator SPR. As described above, the separator SPR may have a closed line shape for the second area AA2, and thus the second-second electrode CE2 and the second intermediate layer IML2 may have a divided shape for the second area AA2. For example, the second-first electrode CE1 and the second-second electrode CE2 may be electrically independent of each other, and the first intermediate layer IML1 and the second intermediate layer IML2 may be electrically independent of each other.

The separator SPR will be described below in more detail with reference to FIGS. 7 and 8B. As illustrated in FIG. 8B, the separator SPR may have an inverted tapered shape. For example, the angle θ (hereinafter, referred to as the taper angle) formed by a side surface SPR_W of the separator SPR with respect to the upper surface of the pixel defining layer PDL may be an obtuse angle in a cross-sectional view. However, it is not necessarily limited thereto, and the taper angle θ may vary as long as the separator SPR is capable of electrically disconnecting the second-first electrode CE1 and the second-second electrode CE2 from each other. In addition, the separator SPR may have the same structure as the tip portion TP and is not necessarily limited thereto.

The separator SPR may include an insulating material. For example, the separator SPR may include an organic insulating material. Alternatively, the separator SPR may include an inorganic insulating material. The separator SPR may be constituted by multiple layers of an organic insulating material and an inorganic insulating material. The separator SPR may include a conductive material. For example, no special limitation necessarily applies to the type of material of the separator SPR as long as the separator SPR is capable of electrically disconnecting the second-first electrode CE1 and the second-second electrode CE2 from each other.

A dummy layer UP may be disposed on (e.g., disposed directly thereon) the separator SPR. The dummy layer UP may include a first dummy layer UP1 disposed on (e.g., disposed directly thereon) the separator SPR and a second dummy layer UP2 disposed on (e.g., disposed directly thereon) the first dummy layer UP1. The first dummy layer UP1 may be formed through the same process as the intermediate layer IML and may include the same material as the intermediate layer IML. The second dummy layer UP2 may be formed through the same process as the second electrode CE and may include the same material as the second electrode CE. For example, the first dummy layer UP1 and the second dummy layer UP2 may be simultaneously formed in the process of forming the intermediate layer IML and the second electrode CE. However, they are not necessarily limited thereto. For example, the display panel DP may not include the dummy layer UP.

As illustrated in FIG. 8B, the second-second electrode CE2 may include a first end EN1a, and the second dummy layer UP2 may include a second end EN2a. The first end EN1a may be spaced apart from the separator SPR and may be located on (e.g., disposed directly thereon) the pixel defining layer PDL, and the second end EN2a may be separated from the first end EN1a and may be located on (e.g., disposed directly thereon) the side surface SPR_W of the separator SPR. However, although the first end EN1a is illustrated as being spaced apart from the side surface SPR_W of the separator SPR at a certain interval in FIG. 8B, they are not necessarily limited thereto, and the first end EN1a may directly contact with the side surface SPR_W of the separator SPR as long as the first end EN1a is electrically disconnected from the second end EN2a. In addition, even though the first end EN1a and the second end EN2a are connected without being distinguished from each other, the second-first electrode CE1 and the second-second electrode CE2 may be considered to be divided from each other by the separator SPR if the second-first electrode CE1 and the second-second electrode CE2 are electrically disconnected from each other when a portion formed along the side surface SPR_W of the separator SPR is sufficiently thin so that the electrical resistance is high.

Referring again to FIG. 7, the encapsulation layer TFE may be disposed on the light emitting element layer LDL. The encapsulation layer TFE may cover the second light emitting element OLED2 and the separator SPR. The encapsulation layer TFE may include a first inorganic layer IL1, an organic layer OL, and a second inorganic layer IL2 sequentially stacked one above another (e.g., in the third direction DR3). However, they are not necessarily limited thereto, and the encapsulation layer TFE may further include a plurality of inorganic layers and a plurality of organic layers. In addition, the encapsulation layer TFE may be a glass substrate.

The first inorganic layer IL1 and the second inorganic layer IL2 may protect the second light emitting element OLED2 from moisture and oxygen outside the display panel DP, and the organic layer OL may protect the second light emitting element OLED2 from foreign matter such as particles remaining in the process of forming the first inorganic layer IL1. The first inorganic layer IL1 and the second inorganic layer IL2 may include a silicon nitride layer, a silicon oxy nitride layer, a silicon oxide layer, a titanium oxide layer, or an aluminum oxide layer. The organic layer OL may include an acrylic organic layer. However, they are not necessarily limited thereto.

The sensing layer ISL may sense an external input. The sensing layer ISL may be formed on the encapsulation layer TFE through a continuous process. The sensing layer ISL may be expressed as being directly disposed on the encapsulation layer TFE. The expression "directly disposed" used herein may mean that another component is not disposed between the sensing layer ISL and the encapsulation layer TFE. For example, a separate adhesive member may not be disposed between the sensing layer ISL and the encapsulation layer TFE. However, the sensing layer ISL may be separately formed and then coupled with the display panel DP through an adhesive member.

The sensing layer ISL may include a plurality of conductive layers and a plurality of insulating layers. The plurality of conductive layers may include a first sensing conductive layer MTL1 and a second sensing conductive layer MTL2, and the plurality of insulating layers may include a first sensing insulation layer 71, a second sensing insulation layer 72, and a third sensing insulation layer 73. However, they are not necessarily limited thereto, and the number of conductive layers and the number of insulating layers may vary.

Each of the first sensing insulation layer 71, the second sensing insulation layer 72, and the third sensing insulation layer 73 may have a single-layer structure or may have a multi-layer structure stacked in the third direction DR3. Each of the first sensing insulation layer 71, the second sensing insulation layer 72, and the third sensing insulation layer 73 may include an inorganic film. The inorganic film may include at least one of aluminum oxide, titanium oxide, silicon oxide, silicon nitride, silicon oxy nitride, zirconium oxide, and hafnium oxide. Each of the first sensing insulation layer 71, the second sensing insulation layer 72, and the third sensing insulation layer 73 may include an organic film. The organic film may include at least one of an acrylic resin, a methacrylic resin, a polyisoprene resin, a vinyl resin, an epoxy resin, a urethane-based resin, a celluosic resin, a siloxane-based resin, a polyimide resin, a polyamide resin, and a perylene-based resin.

The first sensing conductive layer MTL1 may be disposed between the first sensing insulation layer 71 and the second sensing insulation layer 72, and the second sensing conductive layer MTL2 may be disposed between the second sensing insulation layer 72 and the third sensing insulation layer 73. A portion of the second sensing conductive layer MTL2 may be connected with the first sensing conductive layer MTL1 through a contact hole CNT formed in the second sensing insulation layer 72. Each of the first sensing conductive layer MTL1 and the second sensing conductive layer MTL2 may have a single-layer structure or may have a multi-layer structure stacked in the third direction DR3.

A sensing conductive layer having a single-layer structure may include a metal layer or a transparent conductive layer. The metal layer may include molybdenum, silver, titanium, copper, aluminum, or an alloy thereof. The transparent conductive layer may include transparent conductive oxide such as indium tin oxide (ITO), indium zinc oxide (IZO), zinc oxide (ZnO), indium zinc tin oxide (IZTO), or the like. Alternatively, the transparent conductive layer may include a conductive polymer such as PEDOT, a metal nano-wire, or graphene.

A sensing conductive layer having a multi-layer structure may include metal layers. The metal layers may have, for example, a three-layer structure of titanium (Ti)/aluminum (Al)/titanium (Ti). Alternatively, the sensing conductive layer having the multi-layer structure may include at least one metal layer and at least one transparent conductive layer.

In the sensing layer ISL, the first sensing conductive layer MTL1 and the second sensing conductive layer MTL2 may constitute a sensor that senses an external input. The sensor may be driven in a capacitance type. For example, the sensor may be driven in a mutual-capacitance or self-capacitance type. However, the sensor may be driven in a resistive type, an ultrasonic type, or an infrared type in addition to the capacitance type.

Each of the first sensing conductive layer MTL1 and the second sensing conductive layer MTL2 may include transparent conductive oxide and may have a metal mesh shape formed of an opaque conductive material. As long as the visibility of an image displayed by the display panel DP is not deteriorated, the first sensing conductive layer MTL1 and the second sensing conductive layer MTL2 may have various materials and various shapes.

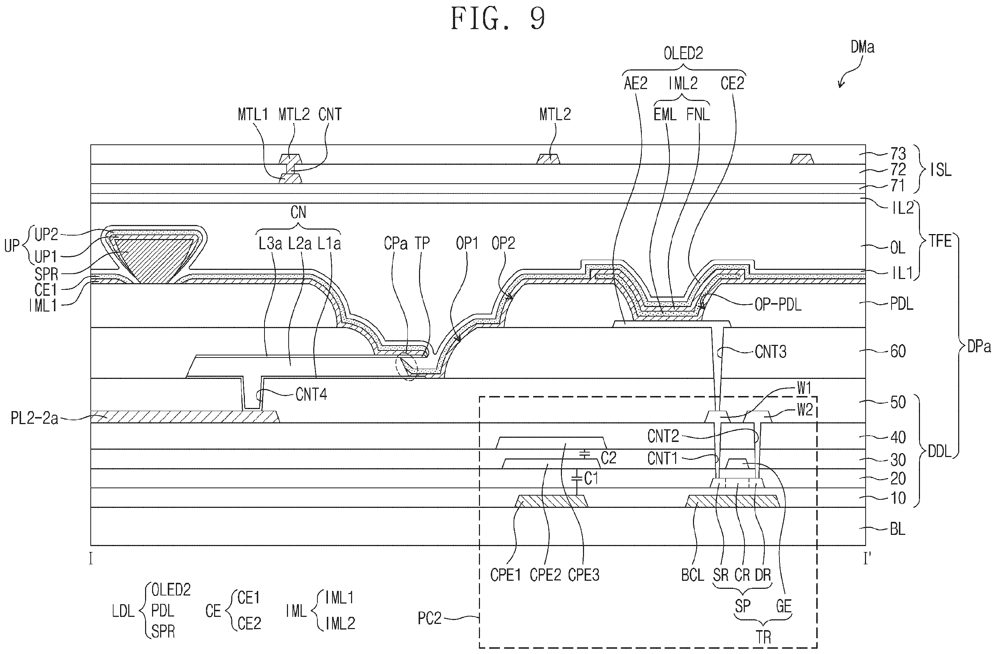

FIG. 9 is a cross-sectional view of a display module. Hereinafter, repetitive descriptions of similar or identical elements already given above may be omitted for economy of description.

Referring to FIG. 9, the display module DMa of the present disclosure may include a connecting line CN electrically connected with a second-second power line PL2-2a. The connecting line CN may be disposed on a layer different from the layer on which the second-second power line PL2-2a is disposed. For example, the second-second power line PL2-2a may be disposed on (e.g., disposed directly thereon) a fourth insulating layer 40, and the connecting line CN may be disposed on (e.g., disposed directly thereon) a fifth insulating layer 50. The connecting line CN may be electrically connected with the second-second power line PL2-2a through a fourth contact hole CNT4 formed through the fifth insulating layer 50.

The connecting line CN may have a three-layer structure. For example, the connecting line CN may include a first layer L1a, a second layer L2a, and a third layer L3a sequentially stacked one above another in the third direction DR3. The second layer L2a may include a material different from that of the first layer L1a. In addition, the second layer L2a may include a material different from that of the third layer L3a. The second layer L2a may have a greater thickness than the first layer L1a. In addition, the second layer L2a may have a greater thickness than the third layer L3a. The second layer L2a may include a highly conductive material. For example, the second layer L2a may include aluminum (Al).

The connecting line CN may include a connection part CPa. The connection part CPa may have a shape in which a side surface L2_W of the second layer L2a is recessed inward from a side surface L1_W of the first layer L1a . For example, the connection part CPa may have an undercut shape or an overhang structure, and a tip portion TP of the connection part CPa may be defined by a portion of the third layer L3a that protrudes relative to the second layer L2a (e.g., in a horizontal direction parallel to an upper surface of the base layer BL).

The connecting line CN may directly contact a second-second electrode CE2. For example, one end EN1 of the second-second electrode CE2 may be disposed along the side surface of the second layer L2a and may directly contact the side surface L2_W of the second layer L2a. Thus, the second-second electrode CE2 may be connected to the connecting line CN and may be connected to (e.g., electrically connected thereto) the second-second power line PL2-2a that is connected with the connecting line CN.

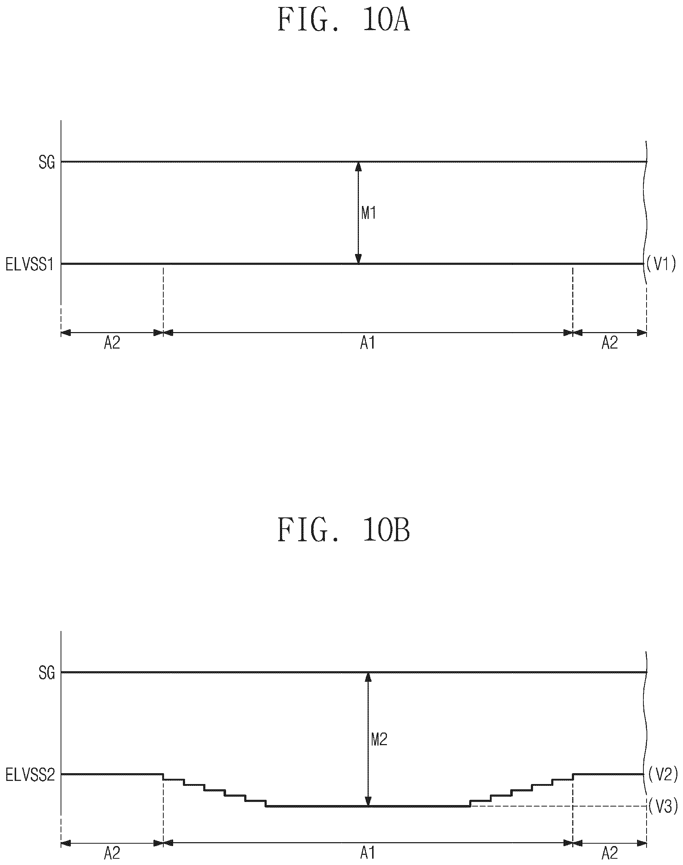

FIG. 10A is a graph depicting voltages applied to the first pixels disposed in the first area illustrated in FIG. 5. FIG. 10B is a graph depicting voltages applied to the second pixels disposed in the second area illustrated in FIG. 5. FIGS. 10A and 10B are graphs depicting the voltages applied to the first pixels and the second pixels during a light emission period.

Referring to FIGS. 4A and 10A, during the light emission period, the first light emitting element OLED1 may emit light depending on a voltage corresponding to a difference between a signal transferred through the sixth transistor T6 and the first voltage ELVSS1. The signal transferred through the sixth transistor T6 may be defined as a transfer signal SG. For example, the luminance of the first light emitting element OLED1 may be determined in correspondence to the difference between the voltage level of the transfer signal SG and the voltage level of the first voltage ELVSS1, and as the difference between the transfer signal SG and the first voltage ELVSS1 is increased, the luminance of the first light emitting element OLED1 may be increased.

Hereinafter, for convenience of description, the level of the transfer signal SG is illustrated as remaining constant during a first period A1 and a second period A2. However, it is not necessarily limited thereto. For example, the level of the transfer signal SG may vary depending on the data signal DS (refer to FIG. 3). The second period A2 may be a time period that does not include the first time period A1. For example, the second period A2 may be all time periods except for the first period A1.

Referring to FIG. 10A, the difference between the voltage level of the transfer signal SG and the voltage level V1 of the first voltage ELVSS1 may be the same during the first period A1 and the second period A2. Therefore, the voltage level V1 of the first voltage ELVSS1 may be constant during the first period A1 and the second period A2. Thus, the luminance of the first light emitting element OLED1 may be constant because the voltage level of the transfer signal SG is constant during the first period A1 and the second period A2. However, it is not necessarily limited thereto, and the voltage level of the transfer signal SG may be varied during the first period A1 and the second period A2 so that the luminance of the first light emitting element OLED1 may be varied during the first period A1 and the second period A2.

Referring to FIGS. 4B and 10B, during the light emission period, the second light emitting element OLED2 may emit light depending on a voltage corresponding to a difference between a signal transferred through the sixth transistor T6 and the second voltage ELVSS2. For example, the luminance of the second light emitting element OLED2 may correspond to the difference between the voltage level of the transfer signal SG and the voltage level of the second voltage ELVSS2, and as the difference between the transfer signal SG and the second voltage ELVSS2 is increased, the luminance of the second light emitting element OLED2 may be increased.

Referring to FIG. 10B, the voltage level V3 of the second voltage ELVSS2 during the first period A1 may be different from the voltage level V2 of the second voltage ELVSS2 during the second period A2. For example, the voltage level V2 of the second voltage ELVSS2 during the second period A2 may be greater than the voltage level V3 of the second voltage ELVSS2 during the first period A1. Thus, the luminance of the second light emitting element OLED2 during the first period A1 may be greater than the luminance of the second light emitting element OLED2 during the second period A2 because the voltage level of the transfer signals SG is constant and the difference between the second voltage ELVSS2 and the transfer signals SG during the first period A1 is greater than the difference between the second voltage ELVSS2 and the transfer signals SG during the second period A2.

Referring to FIGS. 10A and 10B, the voltage level V1 of the first voltage ELVSS1 may be equal to the voltage level V2 of the second voltage ELVSS2 during the second period A2. In addition, the voltage level V1 of the first voltage ELVSS1 in the first period A1 may be different from the voltage level V3 of the second voltage ELVSS2 in the first period A1. For example, the voltage level V1 of the first voltage ELVSS1 in the first period A1 may be greater than the voltage level V3 of the second voltage ELVSS2 in the first period A1. For example, the difference M1 between the voltage level of the transfer signal SG and the voltage level V1 of the first voltage ELVSS1 in the first period A1 may be less than the difference M2 between the voltage level of the transfer signal SG and the voltage level V3 of the second voltage ELVSS2 in the first period A1. Thus, in the first period A1, the luminance of the second light emitting element OLED2 may be greater than the luminance of the first light emitting element OLED1, and in the second period A2 which may include all other time periods than the first period A1, the luminance of the second light emitting element OLED2 may be equal to the luminance of the first light emitting element OLED1. However, they are not necessarily limited thereto and there may be more than two periods in which the levels of luminance of the second light emitting element OLED2 may further vary.

Referring to FIGS. 5, 10A, and 10B, the first pixels PX1 disposed in the first area AA1 may emit light having a luminance corresponding to the difference M1 between the voltage level of the transfer signal SG and the voltage level V1 of the first voltage ELVSS1 during the first period A1, and the second pixels PX2 disposed in the second area AA2 may emit light having a luminance corresponding to the difference M2 between the voltage level of the transfer signal SG and the voltage level V3 of the second voltage ELVSS2 during the first period A1. Therefore, the level of luminance in the pixels in different areas of the display area, such as the first area AA1 and the second area AA2, may be efficiently and precisely customized by the independent voltage levels provided thereto. For example, the display panel DP may display an image on a specific area (e.g., the second area AA2) of the display area DA with a luminance different from that of another area (e.g., the first area AA1), and thus the display quality of the display panel DP may be increased. For example, the luminance may be increased in the second area AA2 which may have a smaller number of pixels in a same area as compared with the first area AA1 thus preventing the user from perceiving differences in brightness levels in different areas of the display area. In addition, since only the voltage level of the second voltage ELVSS2 has only to be adjusted to increase the luminance of the second area AA2, the second voltage ELVSS2 may be customized to have a voltage level required for the second pixels PX2, and thus power consumption may be reduced.

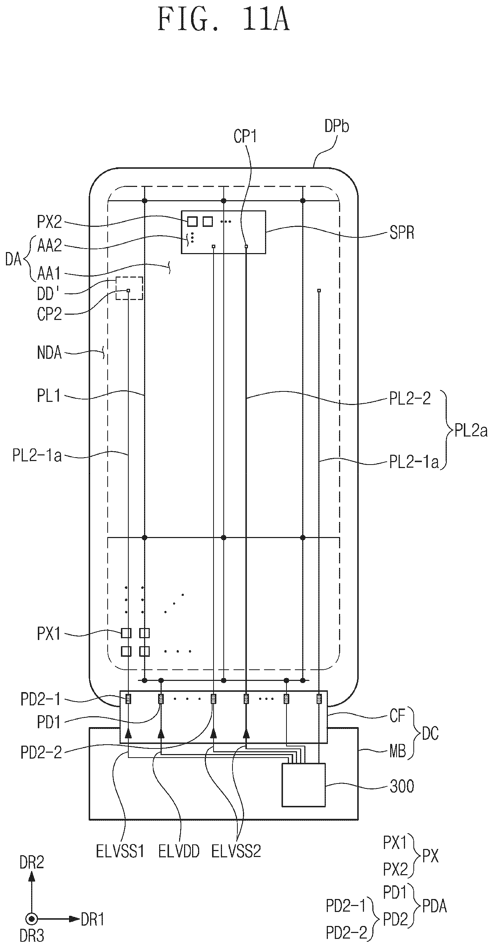

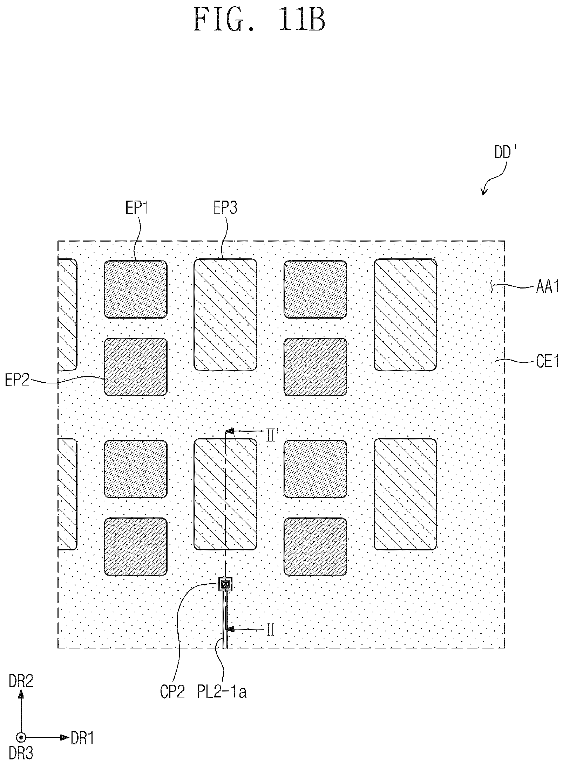

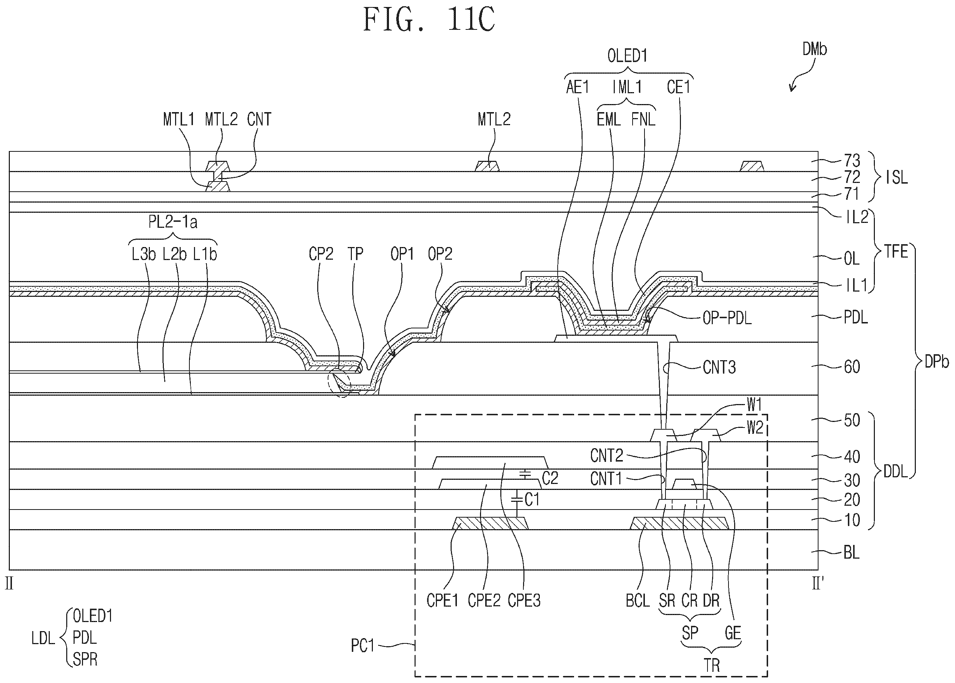

FIG. 11A is a plan view of a display panel and a drive circuit. FIG. 11B is an enlarged view of area DD' illustrated in FIG. 11A. FIG. 11C is a cross-sectional view of a display module corresponding to line II-II' illustrated in FIG. 11B. Hereinafter, repetitive descriptions of similar or identical elements to ones already given above may be omitted for economy of description.

Referring to FIG. 11A, the display panel DPb may include a first power line PL1 and a second power line PL2a. The second power line PL2a may include a second-first power line PL2-1a and a second-second power line PL2-2. Each of the second-first power line PL2-1a and the second-second power line PL2-2 may overlap a display area DA (e.g., in the third direction DR3). Each of the second-first power line PL2-1a and the second-second power line PL2-2 may extend in the second direction DR2.

The second-first power line PL2-1a may overlap a first area AA1. The second-first power line PL2-1a may be electrically connected to first pixels PX1. The second-first power line PL2-1a may be electrically connected to a second-first electrode CE1 of the first pixels PX1 and may provide the first voltage ELVSS1 to the second-first electrode CE1 of the first pixels PX1. For example, the second-first power line PL2-1a may supply the first voltage ELVSS1 to the second-first electrode CE1 through a second connection part CP2. The second-second power lines PL2-2 may be electrically connected to second pixels PX2. The second-second power lines PL2-2 may be electrically connected to a second-second electrode CE2 of the second pixels PX2 and may supply the second voltage ELVSS2 to the second-second electrode CE2 of the second pixels PX2. For example, the second-second power line PL2-2 may supply the second voltage ELVSS2 to the second-second electrode CE2 through a first connection part CP1.

A plurality of second-first power lines PL2-1a and a plurality of second-second power lines PL2-2 may be provided. The second-first power lines PL2-1a and the second-second power lines PL2-2 may extend in the second direction DR2 and may be arranged in the first direction DR1. Although two second-first power lines PL2-1a are illustrated in FIG. 11A, three or more second-first power lines PL2-1a may be provided. A plurality of first connection parts CP1 and a plurality of second connection parts CP2 may be provided.

Referring to FIGS. 11A and 11B, the second-first electrode CE1 may be commonly disposed throughout the first area AA1. For example, the second-first electrode CE1 may be a common electrode and may be commonly deposited by an open mask. The second-first power line PL2-1a may include the second connection part CP2. The second connection part CP2 may be provided on one side of the second-first power line PL2-1a.

Referring to FIG. 11C, the second-first power line PL2-1a may be disposed on a fifth insulating layer 50. The second-first power line PL2-1a may have a three-layer structure. For example, the second-first power line PL2-1a may include a first layer L1b, a second layer L2b, and a third layer L3b sequentially stacked one above another in the third direction DR3. The second-first power line PL2-1a may include the same structure as the second-second power line PL2-2 illustrated in FIG. 7.

The second-first power line PL2-1a may include the second connection part CP2. The second connection part CP2 may have a shape in which a side surface L2_W of the second layer L2b is recessed inward from a side surface L1_W of the first layer L1b. For example, the second connection part CP2 may have an undercut shape or an overhang structure, and a tip portion TP of the second connection part CP2 may be defined by a portion of the third layer L3b that protrudes relative to the second layer L2b (e.g., in a horizontal direction parallel to an upper surface of the base layer BL).

The second-first power line PL2-1a may directly contact the second-first electrode CE1. For example, one end of the second-first electrode CE1 may be disposed along the side surface L2_W of the second layer L2b and may be in direct contact with the side surface L2_W of the second layer L2b. Thus, the second-first electrode CE1 may be connected to the second-first power line PL2-1a.

Referring to FIGS. 11A to 11C, the second-first power line PL2-1a may not be disposed in the non-display area NDA and may be disposed in the first area AA1 of the display area DA. The second-first power line PL2-1a may supply the first voltage ELVSS1 to the second-first electrode CE1 through the second connection part CP2. Since the second-first power line PL2-1a is disposed in the display area DA, the area occupied by the second-first power line PL2-1a in the non-display area NDA may be decreased, and thus the area of dead space of the display panel DPb may be reduced.

In addition, as compared with an embodiment in which the second-first power line PL2-1a is disposed in the non-display area NDA and supplies the first voltage ELVSS1 to the second-first electrode CE1, a voltage drop IR-DROP occurring as the path of current applied to the second-first electrode CE1 disposed in the middle of the display panel DP is increased may be prevented, and deterioration in the display quality of the display device DD (refer to FIG. 1) may be prevented.

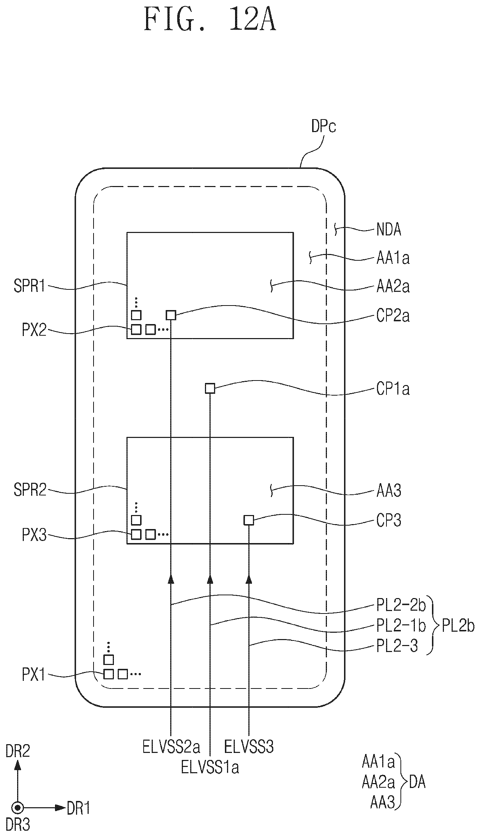

FIGS. 12A to 12C are plan views of display panels.

Referring to FIG. 12A, a display panel DPc of the present disclosure may include a display area DA and a non-display area NDA. The display area DA may include a first area AA1a, a second area AA2a, and a third area AA3. The first area AA1a, the second area AA2a, and the third area AA3 may be divided from one another by separators SPR1 and SPR2. For example, the first area AA1a and the second area AA2a may be divided from each other by the first separator SPR1, and the first area AA1a and the third area AA3 may be divided from each other by the second separator SPR2. The second area AA2a and the third area AA3 may be spaced apart from each other in the second direction DR2 with the first area AA1a therebetween. For example, each of the second area AA2a and the third area AA3 may be surrounded by the first area AA1a.

Pixels PX may be disposed in the display area DA. First pixels PX1 among the pixels PX may be disposed in the first area AA1a, second pixels PX2 among the pixels PX may be disposed in the second area AA2a, and third pixels PX3 among the pixels PX may be disposed in the third area AA3.

A second power line PL2b may include a second-first power line PL2-1b, a second-second power line PL2-2b, and a second-third power line PL2-3. Each of the second-first power line PL2-1b, the second-second power line PL2-2b, and the second-third power line PL2-3 may overlap the display area DA. Each of the second-first power line PL2-1b, the second-second power line PL2-2b, and the second-third power line PL2-3 may extend in the second direction DR2.

The second-first power line PL2-1b may be electrically connected to the first pixels PX1 disposed in the first area AA1a. The second-first power line PL2-1b may supply a first voltage ELVSS1a to the first pixels PX1 through a first connection part CP1a. The second-second power line PL2-2b may be electrically connected to the second pixels PX2 disposed in the second area AA2a. The second-second power line PL2-2b may supply a second voltage ELVSS2a to the second pixels PX2 through a second connection part CP2a. The second-third power line PL2-3 may be electrically connected to the third pixels PX3 disposed in the third area AA3. The second-third power line PL2-3 may supply a third voltage ELVSS3 to the third pixels PX3 through a third connection part CP3.

The first voltage ELVSS1a, the second voltage ELVSS2a, and the third voltage ELVSS3 may be independently supplied to the pixels PX. For example, the first pixels PX1 disposed in the first area AA1a, the second pixels PX2 disposed in the second area AA2a, and the third pixels PX3 disposed in the third area AA3 may emit light of different luminance values in the same light emission period for the same gray level. In the same light emission period (e.g., the first period A1 illustrated in FIG. 10B), the second voltage ELVSS2a and the third voltage ELVSS3 may be less than the first voltage ELVSS1a. Accordingly, in the same light emission period, the second pixels PX2 disposed in the second area AA2a and the third pixels PX3 disposed in the third area AA3 may emit light of higher luminance than the first pixels PX1 disposed in the first area AA1a when there is constant transfer signals SG in the first to third areas AA1a, AA2a, AA3. In addition, when a test unit that senses a voltage drop is inserted into each of the second-first power line PL2-1b, the second-second power line PL2-2b, and the second-third power line PL2-3, a voltage drop phenomenon of the first to third pixels disposed in the first area AA1a, the second area AA2a, and the third area AA3 may be sensed in advance to prevent deterioration in the display quality of the display panel DPc.

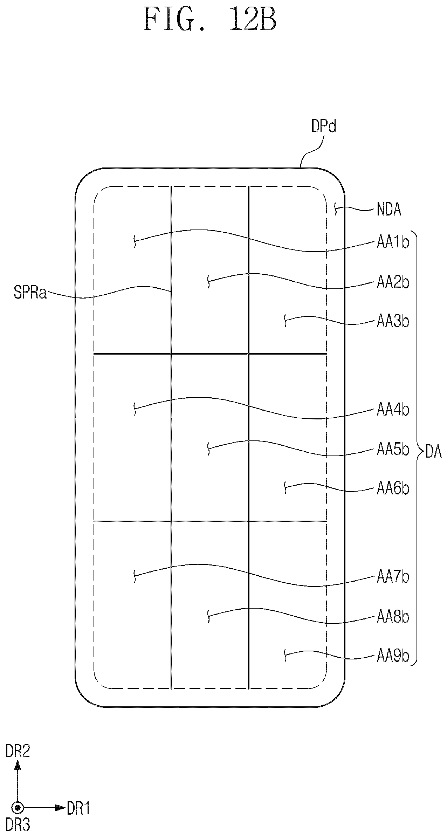

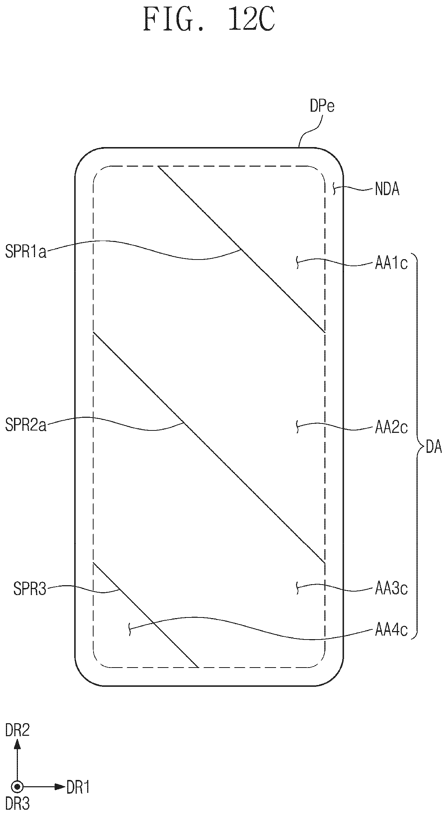

Although the second power line PL2b and the connection parts CP1a, CP2a, and CP3 are omitted in FIGS. 12B and 12C, description similar to that of FIG. 12A may be applied.

Referring to FIG. 12B, a display panel DPd may include a display area DA and a non-display area NDA. The display area DA may include first to ninth areas AA1b to AA9b. The first to ninth areas AA1b to AA9b may be divided from one another by a separator SPRa. The first to ninth areas AA1b to AA9b may have the same shape as each other (e.g., in plan view). The first to ninth areas AA1b to AA9b may be disposed in a grid form (e.g., in a plan view). However, embodiments are not necessarily limited to that illustrated in FIG. 12B, and the first to ninth areas AA1b to AA9b may be disposed in various ways.

A second power line PL2 may include second-first to second-ninth power lines that apply different voltages to first to ninth pixels disposed in the first to ninth areas AA1b to AA9b. Accordingly, the first to ninth pixels may emit light of different luminance values for the same gray level (e.g., having constant transfer signals SG).

Referring to FIG. 12C, a display panel DPe may include a display area DA and a non-display area NDA. The display area DA may include first to fourth areas AA1c to AA4c. The first to fourth areas AA1c to AA4c may be divided from one another by separators SPR1a, SPR2a, and SPR3. For example, the first area AA1c and the second area AA2c may be divided from each other by the first separator SPR1a, the second area AA2c and the third area AA3c may be divided from each other by the second separator SPR2a, and the third area AA3c and the fourth area AA4c may be divided from each other by the third separator SPR3. The first to fourth areas AA1c to AA4c may be arranged in a diagonal direction with respect to the first direction DR1 and the second direction DR2.

A second power line PL2 may include second-first to second-fourth power lines that apply different voltages to first to fourth pixels disposed in the first to fourth areas AA1c to AA4c. Accordingly, the first to fourth pixels may emit light of different luminance values for the same gray level (e.g., having constant transfer signals SG).

The display area may include the first area and the second area divided from each other by the separator. The first voltage applied to the first pixels disposed in the first area and the second voltage applied to the second pixels disposed in the second area may be different from each other. Accordingly, the first area and the second area may display an image with different luminance values in the same light emission period, and thus the display quality of the display panel may be increased.

In addition, since only the voltage level of the second voltage has only to be adjusted to increase the luminance of the second area, the second voltage may be customized to have a voltage level required for the second pixels, and thus power consumption may be reduced.

While the present invention has been described with reference to non-limiting embodiments thereof, it will be apparent to those of ordinary skill in the art that various changes and modifications may be made thereto without departing from the scope of the present invention as defined by the claims.

## Claims

1. A display device comprising:
a base layer including a display area having a plurality of pixels disposed therein and a non-display area disposed around the display area;
a first power line electrically connected to the plurality of pixels; and
a second power line electrically connected to the plurality of pixels,
wherein the display area is divided into a plurality of areas including a first area and a second area,
wherein the second power line includes:
a second-first power line applying a first voltage to first pixels of the plurality of pixels that are disposed in the first area; and
a second-second power line applying a second voltage to second pixels of the plurality of pixels that are disposed in the second area,
wherein during a first period, the first voltage has a voltage level different from a voltage level of the second voltage, and
wherein during a second period that does not include the first period, the first voltage has the same voltage level as the second voltage.

2. The display device of claim 1, wherein each of the plurality of pixels includes:
a pixel driver disposed on the base layer, the pixel driver including a transistor; and
a light emitting element disposed on the transistor, the light emitting element including a first electrode, an intermediate layer disposed on the first electrode, and a second electrode disposed on the intermediate layer,
wherein the first power line is electrically connected with the transistor, and
wherein the second power line is electrically connected with the second electrode.

3. The display device of claim 2, further comprising:
a separator dividing the display area into the plurality of areas, the separator having an obtuse taper angle in a cross-sectional view,
wherein the second electrode includes a second-first electrode and a second-second electrode electrically isolated from each other by the separator, and
wherein the second-first electrode is disposed in the first area, and the second-second electrode is disposed in the second area.

4. The display device of claim 3, wherein:
the second-first electrode is electrically connected with the second-first power line,
the second-second electrode is electrically connected with the second-second power line and the second area includes a first connection part electrically connecting the second-second power line and the second-second electrode with each other

5. The display device of claim 4, wherein:
the first connection part includes a first layer, a second layer disposed on the first layer, and a third layer disposed on the second layer; and
a side surface of the third layer protrudes outward from a side surface of the second layer in a horizontal direction, and the second-second electrode is in direct contact with the side surface of the second layer.

6. The display device of claim 5, wherein:
a tip portion is defined by the side surface of the third layer; and
the second-second electrode is partially cut off by the tip portion.

7. The display device of claim 4, wherein the second-second power line includes the first connection part, and the second-second electrode directly contacts the second-second power line.

8. The display device of claim 4, further comprising:
a connecting line disposed on a layer different from a layer at which the second-second power line is disposed, the connecting line being electrically connected with the second-second power line through a contact hole,
wherein the connecting line includes the first connection part, and the second-second electrode directly contacts the connecting line.

9. The display device of claim 4, wherein the first area includes a second connection part, the second connection part electrically connecting the second-first power line and the second-first electrode to each other, and
wherein the second-first power line is disposed in the first area.

10. The display device of any one of the preceding claims, wherein:
the second power line further includes a second-third power line applying a third voltage to first pixels disposed in a third area among the plurality of areas,
wherein during the first period, the voltage level of the first voltage is different from a voltage level of the third voltage.

11. The display device of claim 10, wherein the second area and the third area are spaced apart from each other with the first area therebetween.

12. The display device of claim 10 or 11, wherein each of the second voltage and the third voltage has a lower voltage level than the first voltage.

13. The display device of any one of the preceding claims, wherein:
the second-second power line includes a plurality of second-second power lines,
the second-second power lines are electrically connected to the second pixels, respectively, and
the second-second power lines extend in a first direction and are disposed in the display area.

14. The display device of any one of the preceding claims, wherein during the first period, the first voltage has a higher voltage level than the second voltage.

15. The display device of any one of the preceding claims, wherein:
the first power line applies a first power voltage to the plurality of pixels; and
the first power voltage has a higher voltage level than the first voltage and the second voltage.
